# EUROPEAN PATENT APPLICATION

(11) **EP 4 801 204 A1**
(43) Date of publication of application: **02.09.2026**
(21) Application number: 24890090.4
(22) Date of filing: 17.06.2024
(51) Int. Cl.: H05K 3/46

(54) **MULTILAYER CIRCUIT BOARD, PROCESSING METHOD THEREFOR, CHIP SYSTEM, AND ELECTRONIC DEVICE**

(30) Priority: 16.11.2023 CN 202311531991
(71) Applicant: Huawei Technologies Co., Ltd., Shenzhen, Guangdong 518129 (CN)
(72) Inventor: LIANG, Ying, Shenzhen, Guangdong 518129 (CN); XIE, Zhenlin, Shenzhen, Guangdong 518129 (CN); HAN, Jianhua, Shenzhen, Guangdong 518129 (CN); GAO, Feng, Shenzhen, Guangdong 518129 (CN); YU, Chaowei, Shenzhen, Guangdong 518129 (CN); XIE, Ertang, Shenzhen, Guangdong 518129 (CN)
(74) Representative: Gill Jennings & Every LLP
(86) International application number: PCT/CN2024/099490
(87) International publication number: WO 2025/102721

(57) **Abstract**

This application provides a multi-layer circuit board and a processing method therefor, a chip system, and an electronic device. The processing method includes: processing a second via, a first conductive pattern, and a second conductive pattern on a first substrate, and processing a third via in a second substrate; and stacking and fastening the first substrate, the second substrate, and a first insulation layer through press-fitting. The processing method further includes: performing via-filling electroplating on the first substrate to form a second conductive channel. The processing method further includes: electroplating the second substrate to form a sixth conductive pattern and a third conductive channel, where the first insulation layer includes a first conductive part. The first conductive pattern, the second conductive pattern, and the sixth conductive pattern are electrically connected through the third conductive channel, the first conductive part, and the second conductive channel. By filling the second via and the third via through via-filling electroplating, a routing density and a chip signal transmission capability of the multi-layer circuit board are enhanced, and electrical performance and thermal performance of the multi-layer circuit board are improved. The via-filling electroplating is suitable for mass production, and a process yield is stable.

## Description

The present invention claims priority to Chinese Patent Application No. 202311531991.1, filed with the China National Intellectual Property Administration on November 16, 2023 and entitled "MULTI-LAYER CIRCUIT BOARD AND PROCESSING METHOD THEREFOR, CHIP SYSTEM, AND ELECTRONIC DEVICE", which is incorporated herein by reference in its entirety.

### TECHNICAL FIELD

The present invention relates to the field of chip technologies, and in particular, to a multi-layer circuit board and a processing method therefor, a chip system, and an electronic device.

### BACKGROUND

With increasing difficulty in transistor process scaling, the market imposes increasingly high requirements on performance of chips, demanding faster processing speed of the chips, a larger memory capacity, and lower latency between processors and memories. To meet these requirements, a plurality of chips are usually packaged in a flip-chip ball grid array (FCBGA) package format. In a chip system, the plurality of chips are fastened to an interposer, the interposer is fastened to a package substrate, and the package substrate is fastened to a printed circuit board (PCB). In this way, signals can be transmitted among the chips, the interposer, the package substrate, and the circuit board. By introducing the interposer between the chips and the package substrate, the plurality of chips can be placed close to each other horizontally as a line width capability of a high-density redistribution interconnection layer (RDL) prepared on the interposer can reach 1 µm. This greatly improves bandwidth performance. However, because the chips and the interposer are generally made of a silicon-based material, coefficients of thermal expansion (CTE) of the chips and the interposer differ greatly from those of the package substrate made of an organic material and the circuit board. Consequently, it is difficult to prepare a large-size package, and continuous evolution of the FCBGA package is limited.

The package substrate and the PCB are of a multi-layer stacked structure (referred to as a multi-layer circuit board below), mainly including a plurality of dielectric layers and metal layers. In the conventional technology, the dielectric layer of the multi-layer circuit board is mainly made of an organic material (referred to as an organic substrate below). With development of the large-size package, a glass dielectric material is attracting more attention. A CTE of glass is similar to that of silicon. If the dielectric layer is made of glass (referred to as a glass substrate below), a CTE mismatch between the substrate and both the chip and the interposer can be reduced, to implement a larger substrate and package.

In an existing processing technology of a multi-layer glass substrate, a through hole is first processed in a single-layer glass substrate, then the through hole and a surface conductive pattern are electroplated, then a layer of insulation adhesive film is press-fitted on the glass substrate and a through hole is provided in a position that is on the adhesive film and that corresponds to the through hole in the glass for coating conductive paste in the through hole in the glass and the through hole in the adhesive film, and finally stacked glass substrates are hot-pressed at a time. The adhesive film is used for interlayer bonding, and an electrical interconnection is implemented by using the conductive paste in the through hole.

However, in a processing process in the conventional technology, an electrical interconnection using the conductive paste has problems such as poor conductivity and thermal conductivity, thereby affecting electrical performance and thermal performance of a chip system.

### SUMMARY

In view of this, this application provides a multi-layer circuit board and a processing method therefor, a chip system, and an electronic device, to help resolve a problem of poor conductivity and thermal conductivity in an electrical interconnection in the conventional technology.

A first aspect of embodiments of this application provides a method for processing a multi-layer circuit board. The method for processing a multi-layer circuit board includes: preparing a core board, where the core board includes a first conductive channel extending in a thickness direction of the core board; preparing a first sub-board, where the first sub-board includes a second via extending in a thickness direction of the first sub-board, the first sub-board includes a first surface and a second surface that are disposed opposite to each other in the thickness direction of the first sub-board, a first conductive pattern is disposed on the first surface, a second conductive pattern is disposed on the second surface, and a difference between an area proportion of the first conductive pattern on the first surface and an area proportion of the second conductive pattern on the second surface is less than or equal to 50%; preparing a second sub-board, where the second sub-board includes a third via extending in a thickness direction of the second sub-board, the second sub-board includes a third surface and a fourth surface that are disposed opposite to each other in the thickness direction of the second sub-board, a third conductive pattern is disposed on the third surface, a fourth conductive pattern is disposed on the fourth surface, and a difference between an area proportion of the third conductive pattern on the third surface and an area proportion of the fourth conductive pattern on the fourth surface is less than or equal to 50%; taking a first insulation layer and a second insulation layer, and stacking the first sub-board, the first insulation layer, the core board, the second insulation layer, and the second sub-board in a thickness direction of the multi-layer circuit board, where the first insulation layer is located between the first sub-board and the core board, the second insulation layer is located between the core board and the second sub-board, the first conductive pattern is located on a side that is of the first sub-board and that is away from the core board, and the fourth conductive pattern is located on a side that is of the second sub-board and that is away from the core board; fastening the first sub-board, the first insulation layer, the core board, the second insulation layer, and the second sub-board through press-fitting; removing the first conductive pattern and the fourth conductive pattern; electroplating the first sub-board, to form a fifth conductive pattern on the first surface, and fill a second conductive medium into the second via to form a second conductive channel, where the fifth conductive pattern, the second conductive channel, and the second conductive pattern form a signal transmission line structure; and electroplating the second sub-board, to form a sixth conductive pattern on the fourth surface, and fill a third conductive medium into the third via to form a third conductive channel, where the sixth conductive pattern, the third conductive channel, and the third conductive pattern form a signal transmission line structure; and the first sub-board, the core board, and the second sub-board are electrically connected through the second conductive channel, the first conductive part, the first conductive channel, a second conductive part, and the third conductive channel. In this application, both the difference between the area proportion of the first conductive pattern and the area proportion of the second conductive pattern and the difference between the area proportion of the third conductive pattern and the area proportion of the fourth conductive pattern are not greater than 50%, so that the first conductive pattern is similar to the second conductive pattern, and the third conductive pattern is similar to the fourth conductive pattern. In this way, the first sub-board and the second sub-board have similar mechanical features on two sides in the thickness direction. This reduces a risk of warping and deformation of the first sub-board and the second sub-board in a subsequent processing process, thereby reducing difficulty in stacking the first sub-board, the second sub-board, and the core board, and improving accuracy and reliability of an electrical connection between the first sub-board, the core board, the second sub-board, and another element or substrate. In the process of preparing the first sub-board, the first conductive pattern is first removed, and then the fifth conductive pattern and the second conductive channel are prepared. In this way, the fifth conductive pattern, the second conductive channel, and the second conductive pattern form the signal transmission line structure, thereby reducing a loss in a signal transmission process of the multi-layer circuit board. Similarly, in the process of preparing the second sub-board, the fourth conductive pattern is first removed, and then the sixth conductive pattern and the third conductive channel are prepared on a metal layer. In this way, the sixth conductive pattern, the third conductive channel, and the third conductive pattern form the signal transmission line structure, thereby reducing the loss in the signal transmission process of the multi-layer circuit board.

In some embodiments, the step of stacking the first sub-board, the first insulation layer, the core board, the second insulation layer, and the second sub-board includes: respectively placing the first insulation layer and the second insulation layer on two sides of the core board in a thickness direction of the core board; and placing the first sub-board on a side that is of the first insulation layer and that is away from the core board, and placing the second sub-board on a side that is of the second insulation layer and that is away from the core board in the thickness direction of the core board. After the step of fastening the first sub-board, the first insulation layer, the core board, the second insulation layer, and the second sub-board through press-fitting, the method for processing a multi-layer circuit board includes: processing a first through hole in the first insulation layer, and processing a second through hole in the second insulation layer, where the first through hole penetrates the first insulation layer in a thickness direction of the first insulation layer, and the second through hole penetrates the second insulation layer in a thickness direction of the second insulation layer; sputtering a metal layer on a side wall of the first through hole and a side wall of the second through hole; and then performing via-filling electroplating on the first through hole to form the first conductive part, and performing via-filling electroplating on the second through hole to form the second conductive part. In this application, the first conductive part and the second conductive part are processed through via-filling electroplating, to reduce radial sizes required for the first conductive part and the second conductive part. This helps enhance a routing density and a chip signal transmission capability of the multi-layer circuit board. In addition, this helps increase conductivity coefficients and thermal conductivity coefficients of the first conductive part and the second conductive part, thereby helping improve electrical performance and thermal performance of the multi-layer circuit board and the chip system. The via-filling electroplating is suitable for mass production, and a process yield is stable.

In some embodiments, the step of stacking the first sub-board, the first insulation layer, the core board, the second insulation layer, and the second sub-board includes: respectively placing the first insulation layer and the second insulation layer on two sides of the core board in a thickness direction of the core board; processing a first through hole in the first insulation layer, and processing a second through hole in the second insulation layer, where the first through hole penetrates the first insulation layer in a thickness direction of the first insulation layer, and the second through hole penetrates the second insulation layer in a thickness direction of the second insulation layer; placing a fourth conductive medium into the first through hole, and placing a fifth conductive medium into the second through hole, where the fourth conductive medium is solder or conductive paste, and the fifth conductive medium is solder or conductive paste; and placing the first sub-board on a side that is of the first insulation layer and that is away from the core board, and placing the second sub-board on a side that is of the second insulation layer and that is away from the core board in the thickness direction of the core board. In this application, the first through hole and the second through hole are filled by solder or conductive paste, to simplify a method for processing the first through hole and the second through hole, and further reduce processing costs of the multi-layer circuit board and the chip system.

In some embodiments, the step of preparing the core board includes: taking a core substrate, and performing laser induction on the core substrate to form a first phase change channel, where an extension direction of the first phase change channel is parallel to a thickness direction of the core substrate; etching the core substrate having a phase change channel to form a first via; sputtering a metal layer on an exposed surface of the core substrate and a side wall of the first via; covering the exposed surface of the core substrate with photoresist; performing via-filling electroplating on the first via, to form the first conductive channel, where a conductor pattern is formed at two ends of the first conductive channel; and removing the photoresist and the sputtered metal layer. In this application, the first via is processed through laser induction and etching. This improves precision of a processing position and a processing size of the first via, and accuracy of positions at which the core board is electrically connected to the first sub-board and the second sub-board, thereby reducing difficulty in stacking and combining the core board, the first sub-board, and the second sub-board. The first via is filled up with the first conductive medium through via-filling electroplating, to reduce a radial size required for the first via. This helps enhance a routing density and a chip signal transmission capability of the multi-layer circuit board. In addition, this helps increase a conductivity coefficient and a thermal conductivity coefficient of the first conductive channel, thereby helping improve electrical performance and thermal performance of the multi-layer circuit board and the chip system. The via-filling electroplating is suitable for mass production, and a process yield is stable.

In some embodiments, the step of preparing the first sub-board includes: taking a first substrate, where the first substrate includes a first surface and a second surface that are disposed opposite to each other in a thickness direction of the first substrate, and sputtering a metal layer on the first surface and the second surface; covering the first surface with first photoresist and covering the second surface with second photoresist; and performing photolithography on the first surface to form a first pattern, and performing photolithography on the second surface to form a second pattern; electroplating the first pattern and the second pattern to form the first conductive pattern and the second conductive pattern; and removing the first photoresist, the second photoresist, and the metal layer. The step of preparing the second sub-board includes: taking a second substrate, and covering a metal layer on a third surface and a fourth surface; covering the third surface with third photoresist and covering the fourth surface with fourth photoresist; performing photolithography on the third surface to form a third pattern, and performing photolithography on the fourth surface to form a fourth pattern; electroplating the third pattern and the fourth pattern to form the third conductive pattern and the fourth conductive pattern; and removing the third photoresist, the fourth photoresist, and the metal layer. In this application, the first conductive pattern, the second conductive pattern, the third conductive pattern, and the fourth conductive pattern are processed through photolithography and electroplating. This improves accuracy of parameters such as shapes, positions, and sizes of the first conductive pattern, the second conductive pattern, the third conductive pattern, and the fourth conductive pattern, thereby increasing a processing yield of the first sub-board and the second sub-board.

In some embodiments, the step of preparing the first sub-board includes: performing laser induction on the first substrate to form a second phase change channel, where an extension direction of the second phase change channel is parallel to the thickness direction of the first substrate; and etching the first substrate having the second phase change channel to form the second via. The step of preparing the second sub-board includes: performing laser induction on the second substrate to form a third phase change channel, where an extension direction of the third phase change channel is parallel to the thickness direction of the second substrate; and etching the second substrate having the third phase change channel to form the third via. In this application, the second via and the third via are processed through laser induction and etching. This improves precision of a processing position and a processing size of the second via and the third via, and accuracy of a position at which the first substrate is electrically connected to the second substrate, thereby reducing difficulty in stacking and combining the first substrate and the second substrate.

In some embodiments, the step of electroplating the first sub-board includes: sputtering a metal layer on the first surface and a side wall of the second via; covering the first surface with fifth photoresist; performing photolithography on the first surface to form a fifth pattern; electroplating the fifth pattern and the second via to form the fifth conductive pattern and the second conductive channel; and removing the fifth photoresist and the metal layer. The step of electroplating the second sub-board includes: covering a metal layer on the fourth surface and a side wall of the third via; covering the fourth surface with sixth photoresist; performing photolithography on the fourth surface to form a sixth pattern; electroplating the sixth pattern and the third via to form the sixth conductive pattern and the third conductive channel; and removing the sixth photoresist and the metal layer. In this application, the second via and the third via are processed through via-filling electroplating, to reduce radial sizes required for the second via and the third via. This helps increase a routing density of the first sub-board and the second sub-board, thereby helping enhance a routing density and a chip signal transmission capability of the multi-layer circuit board. In addition, this helps increase conductivity coefficients and thermal conductivity coefficients of the first conductive channel, the second conductive channel, and the third conductive channel, thereby helping improve electrical performance and thermal performance of the multi-layer circuit board and the chip system. The via-filling electroplating is suitable for mass production, and a process yield is stable. The fifth conductive pattern and the second conductive channel are electroplated and processed at the same time, and the sixth conductive pattern and the third conductive channel are electroplated and processed at the same time, to simplify processing operations and a processing periodicity of the first sub-board and the second sub-board.

In some embodiments, the method for processing a multi-layer circuit board further includes: preparing a third sub-board, where the third sub-board includes a fourth via extending in a thickness direction of the third sub-board, the third sub-board includes a fifth surface and a sixth surface that are disposed opposite to each other in the thickness direction of the third sub-board, a seventh conductive pattern is disposed on the fifth surface, an eighth conductive pattern is disposed on the sixth surface, and a difference between an area proportion of the seventh conductive pattern on the fifth surface and an area proportion of the eighth conductive pattern on the sixth surface is less than or equal to 50%; taking a third insulation layer, and placing the third insulation layer and the third sub-board on a side that is of the second sub-board and that is away from the core board in a thickness direction of the second sub-board, where the third insulation layer is located between the second sub-board and the third sub-board, and the eighth conductive pattern is located on a side that is of the third sub-board and that is away from the third insulation layer; fastening the second sub-board and the third sub-board through press-fitting; removing the eighth conductive pattern; and electroplating the third sub-board, to form an eleventh conductive pattern on the sixth surface, and fill a fourth conductive medium into the fourth via to form a fourth conductive channel, where the eleventh conductive pattern, the fourth conductive channel, and the seventh conductive pattern form a signal transmission line structure; and the third insulation layer includes a third conductive part, and the third sub-board is electrically connected to the second sub-board through the fourth conductive channel and the third conductive part. In addition/alternatively, the method for processing a multi-layer circuit board further includes: preparing a fourth sub-board, where the fourth sub-board includes a fifth via extending in a thickness direction of the fourth sub-board, the fourth sub-board includes a seventh surface and an eighth surface that are disposed opposite to each other in the thickness direction of the fourth sub-board, a ninth conductive pattern is disposed on the seventh surface, a tenth conductive pattern is disposed on the eighth surface, and a difference between an area proportion of the ninth conductive pattern on the seventh surface and an area proportion of the tenth conductive pattern on the eighth surface is less than or equal to 50%. After the step of fastening the first sub-board, the first insulation layer, the core board, the second insulation layer, and the second sub-board through press-fitting, the method for processing a multi-layer circuit board includes: taking a fourth insulation layer, and placing the fourth insulation layer and the fourth sub-board on a side that is of the first sub-board and that is away from the core board in the thickness direction of the first sub-board, where the fourth insulation layer is located between the fourth sub-board and the first sub-board, and the ninth conductive pattern is located on a side that is of the fourth sub-board and that is away from the fourth insulation layer; fastening the fourth sub-board and the first sub-board through press-fitting; removing the ninth conductive pattern; and electroplating the fourth sub-board, to from a twelfth conductive pattern on the seventh surface, and fill a fifth conductive medium into the fifth via to form a fifth conductive channel, where the twelfth conductive pattern, the fifth conductive channel, and the tenth conductive pattern form a signal transmission line structure; and the fourth insulation layer includes a fourth conductive part, and the fourth sub-board is electrically connected to the first sub-board through the fifth conductive channel and the fourth conductive part. In this application, the multi-layer circuit board further includes the third sub-board and the fourth sub-board, so that a quantity of stacked substrates on the multi-layer circuit board is increased, to meet a signal transmission requirement of a chip system with higher performance. The difference between the area proportion of the seventh conductive pattern and the area proportion of the eighth conductive pattern and the difference between the area proportion of the ninth conductive pattern and the area proportion of the tenth conductive pattern are less than or equal to 50%. In this way, the third sub-board and the fourth sub-board have similar mechanical features on two sides, thereby reducing a risk of deformation of the third sub-board and the fourth sub-board.

A second aspect of this application provides a method for processing a multi-layer circuit board. The method for processing a multi-layer circuit board includes: taking a first substrate, and processing a first conductive pattern, a second conductive pattern, and a second via in the first substrate, where an extension direction of the second via is parallel to a thickness direction of the first substrate, the first substrate includes a first surface and a second surface that are disposed opposite to each other in the thickness direction of the first substrate, the first conductive pattern is located on the first surface, and the second conductive pattern is located on the second surface; taking a second substrate, and processing a third via in the second substrate, where an extension direction of the third via is parallel to a thickness direction of the second substrate; taking a first insulation layer, and stacking the second substrate and the first insulation layer on the first substrate in a thickness direction of the first sub-board, where the first insulation layer is located between the second substrate and the first substrate; and fastening the second substrate, the first insulation layer, and the first substrate through press-fitting; before the step of stacking the second substrate and the first insulation layer on the first substrate, or after the step of fastening the second substrate, the first insulation layer, and the first substrate through press-fitting, the method for processing a multi-layer circuit board includes: performing via-filling electroplating on the first substrate to fill a second conductive medium into the second via, to form a second conductive channel; and after the step of fastening the second substrate, the first insulation layer, and the first substrate through press-fitting, the method for processing a multi-layer circuit board includes: electroplating the second substrate, to form a sixth conductive pattern on a side that is of the second substrate and that is away from the first substrate, and fill a third conductive medium into the third via to form a third conductive channel, where the first insulation layer includes a first conductive part, and the first conductive pattern, the second conductive pattern, and the sixth conductive pattern are electrically connected through the third conductive channel, the first conductive part, and the second conductive channel. In this application, the second via and the third via are filled through via-filling electroplating, to reduce radial sizes required for the second via and the third via. This helps enhance a routing density and a chip signal transmission capability of the multi-layer circuit board. In addition, this helps increase conductivity coefficients and thermal conductivity coefficients of the second conductive channel and the third conductive channel, thereby helping improve electrical performance and thermal performance of the multi-layer circuit board and the chip system. The via-filling electroplating is suitable for mass production, and a process yield is stable.

In some embodiments, when a difference between an area proportion of the first conductive pattern on the first surface and an area proportion of the second conductive pattern on the second surface is less than or equal to 50%, the method for processing a multi-layer circuit board includes: preparing a core board, where the core board includes a first conductive channel extending in a thickness direction of the core board; processing the first conductive pattern and the second conductive pattern on the first substrate; and processing the second via in the first substrate having the first conductive pattern and the second conductive pattern. The step of stacking the second substrate and the first insulation layer on the first substrate includes: taking a second insulation layer, and stacking the first substrate, the first insulation layer, the core board, the second insulation layer, and the second substrate, where the first insulation layer is located between the first substrate and the core board, the second insulation layer is located between the core board and the second substrate, and the first conductive pattern is located on a side that is of the first substrate and that is away from the core board. The step of fastening the second substrate, the first insulation layer, and the first substrate through press-fitting includes: fastening the first substrate, the first insulation layer, the core board, the second insulation layer, and the second substrate through press-fitting. After the step of fastening the first substrate, the first insulation layer, the core board, the second insulation layer, and the second substrate through press-fitting, the method for processing a multi-layer circuit board includes: removing the first conductive pattern; electroplating the first substrate, to form a fifth conductive pattern on the first surface, and fill the second conductive medium into the second via to form the second conductive channel, so as to form the first sub-board, where the fifth conductive pattern, the second conductive channel, and the second conductive pattern form a signal transmission line structure; and the second insulation layer includes a second conductive part, and after the step of electroplating the second substrate to form the sixth conductive pattern and the third conductive channel, the fifth conductive pattern, the second conductive pattern, and the sixth conductive pattern are electrically connected through the second conductive channel, the first conductive part, the first conductive channel, the second conductive part, and the third conductive channel. In this application, the difference between the area proportion of the first conductive pattern on the first surface and the area proportion of the second conductive pattern on the second surface is less than or equal to 50%, so that the first conductive pattern is similar to the second conductive pattern. In this way, the first sub-board has similar mechanical features on two sides in the thickness direction. This reduces a risk of warping and deformation of the first sub-board in a subsequent processing process, thereby reducing difficulty in stacking the first sub-board, the second sub-board, and the core board, and improving accuracy and reliability of an electrical connection between the first sub-board, the core board, the second sub-board, and another element or substrate. In the process of preparing the first sub-board, the first conductive pattern is first removed, and then the fifth conductive pattern and the second conductive channel are prepared. In this way, the fifth conductive pattern, the second conductive channel, and the second conductive pattern form a signal transmission line structure, thereby reducing a signal transmission loss of the multi-layer circuit board.

In some embodiments, the step of preparing the core board includes: taking a core substrate, and performing laser induction on the core substrate to form a first phase change channel, where an extension direction of the first phase change channel is parallel to a thickness direction of the core substrate; etching the core substrate having a phase change channel to form a first via; sputtering a metal layer on an exposed surface of the core substrate; performing via-filling electroplating on the first via, to form the first conductive channel; and removing the metal layer on the surface of the core substrate. In this application, the first via is processed through laser induction and etching. This improves precision of a processing position and a processing size of the first via, and accuracy of positions at which the core board is electrically connected to the first sub-board and the second sub-board, thereby reducing difficulty in stacking and combining the core board, the first sub-board, and the second sub-board. The first via is filled up with the first conductive medium through via-filling electroplating, to reduce a radial size required for the first via. This helps enhance a routing density and a chip signal transmission capability of the multi-layer circuit board. In addition, this helps increase a conductivity coefficient and a thermal conductivity coefficient of the first conductive channel, thereby helping improve electrical performance and thermal performance of the multi-layer circuit board and the chip system. The via-filling electroplating is suitable for mass production, and a process yield is stable.

In some embodiments, before the step of processing the third via in the second substrate, the method for processing a multi-layer circuit board includes: taking the second substrate, where the second substrate includes a third surface and a fourth surface that are disposed opposite to each other in the thickness direction of the second substrate, and processing a third conductive pattern on the third surface and processing a fourth conductive pattern on the fourth surface, to form a second sub-board, where a difference between an area proportion of the third conductive pattern on the third surface and an area proportion of the fourth conductive pattern on the fourth surface is less than or equal to 50%; and after the step of fastening the first substrate, the first insulation layer, the core board, the second insulation layer, and the second substrate through press-fitting, the fourth conductive pattern is located on the side that is of the second substrate and that is away from the first substrate, and the method for processing a multi-layer circuit board includes: removing the fourth conductive pattern. In this application, the difference between the area proportion of the third conductive pattern on the third surface and the area proportion of the fourth conductive pattern on the fourth surface is less than or equal to 50%, so that the third conductive pattern is similar to the fourth conductive pattern. In this way, the second sub-board has similar mechanical features on two sides in the thickness direction. This reduces a risk of warping and deformation of the second sub-board in a subsequent processing process, reduces difficulty in stacking the second sub-board and the core plate, and improves accuracy and reliability of an electrical connection between the second sub-board and the core board and an electrical connection between the second sub-board and an element or a substrate on the second sub-board, thereby increasing a production yield of the multi-layer circuit board and the chip system. In a process of preparing the second sub-board, the fourth conductive pattern is first removed, and then the sixth conductive pattern and the third conductive channel are prepared. In this way, the sixth conductive pattern, the third conductive channel, and the third conductive pattern form a signal transmission line structure, thereby reducing a signal transmission loss of the multi-layer circuit board.

In some embodiments, the step of processing the first conductive pattern and the second conductive pattern on the first substrate includes: taking the first substrate, and sputtering a metal layer on the first surface and the second surface; covering the first surface with first photoresist, and covering the second surface with second photoresist; performing photolithography on the first surface to form a first pattern, and performing photolithography on the second surface to form a second pattern; electroplating the first pattern and the second pattern to form the first conductive pattern and the second conductive pattern; and removing the first photoresist, the second photoresist, and the metal layer. The step of processing the third conductive pattern on the third surface and processing the fourth conductive pattern on the fourth surface includes: taking the second substrate, and sputtering a metal layer on the third surface and the fourth surface; covering the third surface with third photoresist, and covering the fourth surface with fourth photoresist; performing photolithography on the third surface to form a third pattern, and performing photolithography on the fourth surface to form a fourth pattern; electroplating the third pattern and the fourth pattern to form the third conductive pattern and the fourth conductive pattern; and removing the third photoresist, the fourth photoresist, and the metal layer. In this application, the first conductive pattern, the second conductive pattern, the third conductive pattern, and the fourth conductive pattern are processed through photolithography and electroplating. This improves accuracy of parameters such as shapes, positions, and sizes of the first conductive pattern, the second conductive pattern, the third conductive pattern, and the fourth conductive pattern, thereby increasing a processing yield of the first sub-board and the second sub-board.

In some embodiments, the step of electroplating the first substrate includes: sputtering a metal layer on the first surface and a side wall of the second via; covering the first surface with fifth photoresist; performing photolithography on the first surface to form a fifth pattern; electroplating the fifth pattern and the second via to form the fifth conductive pattern and the second conductive channel; and removing the fifth photoresist and the metal layer. The step of electroplating the second substrate includes: sputtering a metal layer on the fourth surface and a side wall of the third via; covering the fourth surface with sixth photoresist; performing photolithography on the fourth surface to form a sixth pattern; electroplating the sixth pattern and the third via to form the sixth conductive pattern and the third conductive channel; and removing the sixth photoresist and the metal layer. In this application, the fifth conductive pattern and the sixth conductive pattern are processed through photolithography and electroplating. This improves accuracy of parameters such as shapes, positions, and sizes of the fifth conductive pattern and the sixth conductive pattern, thereby increasing a processing yield of the first sub-board and the second sub-board. The second conductive channel and the third conductive channel are processed through electroplating, to reduce radial sizes required for the second via and the third via. This helps enhance a routing density and a chip signal transmission capability of the multi-layer circuit board. In addition, this helps increase conductivity coefficients and thermal conductivity coefficients of the second conductive channel and the third conductive channel, thereby helping improve electrical performance and thermal performance of the multi-layer circuit board and the chip system. The via-filling electroplating is suitable for mass production, and a process yield is stable.

In some embodiments, the method for processing a multi-layer circuit board further includes: preparing a third sub-board, where the third sub-board includes a fourth via extending in a thickness direction of the third sub-board, the third sub-board includes a fifth surface and a sixth surface that are disposed opposite to each other in the thickness direction of the third sub-board, a seventh conductive pattern is disposed on the fifth surface, an eighth conductive pattern is disposed on the sixth surface, and a difference between an area proportion of the seventh conductive pattern on the fifth surface and an area proportion of the eighth conductive pattern on the sixth surface is less than or equal to 50%. After the step of fastening the first substrate, the first insulation layer, the core board, the second insulation layer, and the second substrate through press-fitting, the method for processing a multi-layer circuit board includes: taking a third insulation layer, and placing the third insulation layer and the third sub-board on a side that is of the second sub-board and that is away from the core board in a thickness direction of the second sub-board, where the third insulation layer is located between the second sub-board and the third sub-board, and the eighth conductive pattern is located on a side that is of the third sub-board and that is away from the third insulation layer; fastening the second sub-board and the third sub-board through press-fitting; removing the eighth conductive pattern; electroplating the third sub-board, to form an eleventh conductive pattern on the sixth surface, and fill a fourth conductive medium into the fourth via to form a fourth conductive channel, where the eleventh conductive pattern, the fourth conductive channel, and the seventh conductive pattern form a signal transmission line structure; and the third insulation layer includes a third conductive part, and the third sub-board is electrically connected to the second sub-board through the fourth conductive channel and the third conductive part; and/or the method for processing a multi-layer circuit board further includes: preparing a fourth sub-board, where the fourth sub-board includes a fifth via extending in a thickness direction of the fourth sub-board, the fourth sub-board includes a seventh surface and an eighth surface that are disposed opposite to each other in the thickness direction of the fourth sub-board, a ninth conductive pattern is disposed on the seventh surface, a tenth conductive pattern is disposed on the eighth surface, and a difference between an area proportion of the ninth conductive pattern on the seventh surface and an area proportion of the tenth conductive pattern on the eighth surface is less than or equal to 50%. After the step of fastening the first sub-board, the first insulation layer, the core board, the second insulation layer, and the second sub-board through press-fitting, the method for processing a multi-layer circuit board includes: taking a fourth insulation layer, and placing the fourth insulation layer and the fourth sub-board on a side that is of the first sub-board and that is away from the core board in the thickness direction of the first sub-board, where the fourth insulation layer is located between the fourth sub-board and the first sub-board, and the ninth conductive pattern is located on a side that is of the fourth sub-board and that is away from the fourth insulation layer; fastening the fourth sub-board and the first sub-board through press-fitting; removing the ninth conductive pattern; and electroplating the fourth sub-board, to from a twelfth conductive pattern on the seventh surface, and fill a fifth conductive medium into the fifth via to form a fifth conductive channel, where the twelfth conductive pattern, the fifth conductive channel, and the tenth conductive pattern form a signal transmission line structure; and the fourth insulation layer includes a fourth conductive part, and the fourth sub-board is electrically connected to the first sub-board through the fifth conductive channel and the fourth conductive part. In this application, the multi-layer circuit board further includes the third sub-board and the fourth sub-board, so that a quantity of stacked substrates on the multi-layer circuit board is increased, to meet a signal transmission requirement of a chip system with higher performance.

In some embodiments, when the first conductive pattern, the second conductive pattern, and the second conductive channel form a signal transmission line structure, the step of performing via-filling electroplating on the first substrate is performed simultaneously with the step of processing the first conductive pattern and the second conductive pattern; and the step of processing the first conductive pattern, the second conductive pattern, and the second via in the first substrate includes: processing the second via in the first substrate; sputtering a metal layer on the first surface and the second surface of the first substrate having the second via; covering the first surface with first photoresist, and covering the second surface with second photoresist; performing photolithography on the first surface to form a first pattern, and performing photolithography on the second surface to form a second pattern; and electroplating the first pattern, the second pattern, and the second via, to form the first conductive pattern, the second conductive pattern, and the second conductive channel. In this application, the first conductive pattern, the second conductive pattern, and the second conductive channel form the signal transmission line structure, so that the foregoing core board may be omitted. This helps reduce an overall thickness of the multi-layer circuit board.

In some embodiments, the method for processing a multi-layer circuit board further includes: preparing a third sub-board, where the third sub-board includes a fourth via extending in a thickness direction of the third sub-board. After the step of fastening the second substrate, the first insulation layer, and the first substrate through press-fitting, the method for processing a multi-layer circuit board includes: taking a third insulation layer, and placing the third insulation layer and the third sub-board on the side that is of the second substrate and that is away from the first substrate in the thickness direction of the second substrate, where the third insulation layer is located between the second substrate and the third sub-board; fastening the third sub-board and the second substrate through press-fitting; and electroplating the third sub-board, to form an eleventh conductive pattern on a side that is of the third sub-board and that is away from the second substrate, and fill a fourth conductive medium into the fourth via to form a fourth conductive channel, where the third insulation layer includes a third conductive part, and the eleventh conductive pattern is electrically connected to the sixth conductive pattern through the fourth conductive channel and the third conductive part. In addition/alternatively, the method for processing a multi-layer circuit board further includes: preparing a fourth sub-board, where the fourth sub-board includes a fifth via extending in a thickness direction of the fourth sub-board. After the step of fastening the second substrate, the first insulation layer, and the first substrate through press-fitting, the method for processing a multi-layer circuit board includes: taking a fourth insulation layer, and placing the fourth insulation layer and the fourth sub-board on a side that is of the first substrate and that is away from the second substrate in the thickness direction of the first substrate, where the fourth insulation layer is located between the first substrate and the fourth sub-board; fastening the first substrate and the fourth sub-board through press-fitting; and electroplating the fourth sub-board, to form a twelfth conductive pattern on a side that is of the fourth sub-board and that is away from the first substrate, and fill a fifth conductive medium into the fifth via to form a fifth conductive channel, where the fourth insulation layer includes a fourth conductive part, and the twelfth conductive pattern is electrically connected to the first conductive pattern through the fifth conductive channel and the fourth conductive part. In this application, the multi-layer circuit board further includes the third sub-board and the fourth sub-board, so that a quantity of stacked substrates on the multi-layer circuit board is increased, to meet a signal transmission requirement of a chip system with higher performance.

In some embodiments, the step of processing the second via in the first substrate includes: performing laser induction on the first substrate to form a second phase change channel, where an extension direction of the second phase change channel is parallel to the thickness direction of the first substrate; and etching the first substrate having two phase change channels to form the second via. The step of processing the third via in the second substrate includes: performing laser induction on the second substrate to form a third phase change channel, where an extension direction of the third phase change channel is parallel to the thickness direction of the second substrate; and etching the second substrate having three phase change channels to form the third via. In this application, the second via and the third via are processed through laser induction and etching. This improves precision of a processing position and a processing size of the second via and the third via, and accuracy of a position at which the first substrate is electrically connected to the second substrate, thereby reducing difficulty in stacking and combining the first substrate and the second substrate.

In some embodiments, the step of stacking the second substrate and the first insulation layer on the first substrate includes: placing the first insulation layer on the first substrate in the thickness direction of the first sub-board; and placing the second substrate on a side that is of the first insulation layer and that is away from the first substrate in the thickness direction of the first sub-board. After the step of fastening the second substrate, the first insulation layer, and the first substrate through press-fitting, the method for processing a multi-layer circuit board includes: processing a first through hole in the first insulation layer, where the first through hole penetrates the first insulation layer in a thickness direction of the first insulation layer; sputtering a metal layer on a side wall of the first through hole; and performing via-filling electroplating on the first through hole, to form the first conductive part. In this application, the first conductive part and the second conductive part are processed through via-filling electroplating, to reduce radial sizes required for the first conductive part and the second conductive part. This helps enhance a routing density and a chip signal transmission capability of the multi-layer circuit board. In addition, this helps increase conductivity coefficients and thermal conductivity coefficients of the first conductive part and the second conductive part, thereby helping improve electrical performance and thermal performance of the multi-layer circuit board and the chip system. The via-filling electroplating is suitable for mass production, and a process yield is stable.

In some embodiments, the step of stacking the second substrate and the first insulation layer on the first sub-board includes: placing the first insulation layer on the first substrate in the thickness direction of the first substrate; processing a first through hole in the first insulation layer, where the first through hole penetrates the first insulation layer in a thickness direction of the first insulation layer; placing a fourth conductive medium into the first through hole, where the fourth conductive medium is solder or conductive paste; and placing the second substrate on a side that is of the first insulation layer and that is away from the first sub-board in the thickness direction of the first sub-board. In this application, the first through hole and the second through hole are filled by melting solder or conductive paste, to simplify a method for processing the first through hole and the second through hole, thereby reducing processing costs of the first insulation layer and the second insulation layer, and further reducing processing costs of the multi-layer circuit board and the chip system.

A third aspect of this application provides a multi-layer circuit board, where the multi-layer circuit board is formed through processing based on the method for processing a multi-layer circuit board according to any one of the foregoing implementations. In this application, when the first conductive pattern is similar to the second conductive pattern, and the third conductive pattern is similar to the fourth conductive pattern, the first sub-board and the second sub-board have similar mechanical features on two sides in a thickness direction. This reduces a risk of warping and deformation of the first sub-board and the second sub-board in a subsequent processing process, thereby reducing difficulty in stacking the first sub-board, the second sub-board, and the core board. In addition, this helps enhance accuracy and reliability of an electrical connection between the first sub-board, the core board, the second sub-board, and another element or substrate, thereby increasing a production yield of the multi-layer circuit board. When the second via and the third via are filled through via-filling electroplating, radial sizes required for the second via and the third via are reduced. This helps enhance a routing density and a chip signal transmission capability of the multi-layer circuit board. In addition, this helps increase conductivity coefficients and thermal conductivity coefficients of the second conductive channel and the third conductive channel, thereby helping improve electrical performance and thermal performance of the multi-layer circuit board and the chip system. The via-filling electroplating is suitable for mass production, and a process yield is stable.

A fourth aspect of this application provides a chip system. The chip system includes: a printed circuit board and a package substrate, where the package substrate is mounted on the printed circuit board, and the package substrate is electrically connected to the printed circuit board; an interposer, where the interposer is mounted on the package substrate, and the interposer is electrically connected to the package substrate; and a plurality of chip dies, where the chip dies are mounted on the interposer, and the plurality of chip dies are electrically connected to the interposer. The printed circuit board is the multi-layer circuit board according to any one of the foregoing implementations, and/or the package substrate is the multi-layer circuit board according to any one of the foregoing implementations. In this application, because a line width of a redistribution layer on the interposer is small, the plurality of chip dies can be closely arranged on a surface of the interposer. This reduces a gap between adjacent chip dies, and increases a quantity of chip dies that can be disposed in the chip system, thereby improving bandwidth performance of the chip system. When the first conductive pattern is similar to the second conductive pattern, and the third conductive pattern is similar to the fourth conductive pattern, the first sub-board and the second sub-board have similar mechanical features on two sides in a thickness direction. This reduces a risk of warping and deformation of the first sub-board and the second sub-board in a subsequent processing process, thereby reducing difficulty in stacking the first sub-board, the second sub-board, and the core board. In addition, this helps enhance accuracy and reliability of an electrical connection between the first sub-board, the core board, the second sub-board, and another element or substrate, thereby increasing a production yield of the chip system. The second via and the third via are filled through via-filling electroplating, to help enhance a routing density of the multi-layer circuit board and a signal transmission capability of the chip system, and help increase conductivity coefficients and thermal conductivity coefficients of the second conductive channel and the third conductive channel, and further improve electrical performance and thermal performance of the multi-layer circuit board and the chip system. The via-filling electroplating is suitable for mass production, and a process yield is stable. A material of the substrate includes but is not limited to glass, ceramic, sapphire, a resin material, a composite organic material, a composite inorganic material, and the like. The glass material is used as an example. A glass substrate replaces an organic substrate, to reduce a signal transmission loss in a working process of the chip system.

A fifth aspect of this application provides an electronic device, where the electronic device includes a device body and a chip system installed on the device body, and the chip system is the foregoing chip system. In this application, the interposer is disposed in the chip system, to improve bandwidth performance of the chip system, and further enhance working performance of the electronic device. In a process of processing the multi-layer circuit board, the first conductive pattern is similar to the second conductive pattern, and the third conductive pattern is similar to the fourth conductive pattern, to enhance accuracy and reliability of an electrical connection between the first sub-board, the core board, the second sub-board, and another element or substrate, and further improve working stability of the chip system and the electronic device. The second via and the third via are filled through via-filling electroplating, to enhance a signal transmission capability of the chip system and the electronic device, and improve electrical performance and thermal performance of the chip system and the electronic device. In addition, the via-filling electroplating is suitable for mass production, and a process yield is stable. This helps reduce costs of the electronic device.

### BRIEF DESCRIPTION OF DRAWINGS

To describe technical solutions in embodiments of this application more clearly, the following briefly describes the accompanying drawings for embodiments. It is clear that the accompanying drawings in the following descriptions show merely some embodiments of this application, and a person of ordinary skill in the art may derive other drawings from these accompanying drawings without creative efforts.
FIG. 1 is a sectional view of a partial structure of a chip system according to an embodiment of this application;
FIG. 2 is a sectional view of a multi-layer circuit board according to an embodiment of this application;
FIG. 3 is a sectional view of a multi-layer circuit board according to another embodiment of this application;
FIG. 4 is a sectional view of a multi-layer circuit board according to another embodiment of this application;
FIG. 5(a) to FIG. 5(d) are flowcharts of processing a core board according to an embodiment of this application;
FIG. 6(a) to FIG. 6(d) are flowcharts of processing a first sub-board according to an embodiment of this application;
FIG. 7(a) to FIG. 7(d) are flowcharts of processing a second sub-board according to an embodiment of this application;
FIG. 8(a) to FIG. 8(j) are flowcharts of processing the multi-layer circuit board in FIG. 3 according to an embodiment;
FIG. 9(a) to FIG. 9(j) are flowcharts of processing the multi-layer circuit board in FIG. 3 according to another embodiment;
FIG. 10(a) to FIG. 10(f) are flowcharts of processing a first sub-board according to another embodiment of this application;
FIG. 11(a) and FIG. 11(b) are flowcharts of processing a second sub-board according to another embodiment of this application;
FIG. 12(a) to FIG. 12(g) are flowcharts of processing the multi-layer circuit board in FIG. 4 according to an embodiment; and
FIG. 13(a) to FIG. 13(h) are flowcharts of processing the multi-layer circuit board in FIG. 4 according to another embodiment.

Reference numerals:
01: circuit board;
02: package substrate;
03: interposer;
04: chip die;
   041: first chip;
   042: second chip;
   043: third chip;
05: first pin;
06: second pin;
07: third pin;
1: core board;
   11: core substrate;
      111: first phase change channel;
   12: first conductive channel;
      121: first via;
      122: first conductive medium;
2: first sub-board;
   21: first conductive pattern;
   22: second conductive pattern;
   23: first substrate;
      231: first surface;
      232: second surface;
      233: first photoresist;
      234: second photoresist;
      235: second phase change channel;
      236: fifth photoresist;
   24: second conductive channel;
      241: second via;
      242: second conductive medium;
3: second sub-board;
   31: conductive pattern layer;
      311: third conductive pattern;
      312: fourth conductive pattern;
   32: second substrate;
      321: third surface;
      322: fourth surface;
      323: third photoresist;
      324: fourth photoresist;
      325: third phase change channel;
      326: sixth photoresist;
   33: third conductive channel;
      331: third via;
      332: third conductive medium;
4: first insulation layer;
   41: first conductive part;
   411: first through hole;
   412: fourth conductive medium;
5: second insulation layer;
   51: second conductive part;
   511: second through hole;
   512: fifth conductive medium;
6: metal layer;
7: third sub-board;
   71: seventh conductive pattern;
   72: eighth conductive pattern;
8: third insulation layer;
9: fourth sub-board;
   91: ninth conductive pattern;
   92: tenth conductive pattern;
1a: fourth insulation layer;
1b: substrate;
   1b1: conductive channel;
1c: conductive pattern;
1d: insulation layer; and
   1d1: conductive part.

### DESCRIPTION OF EMBODIMENTS

To better understand technical solutions of this application, the following describes embodiments of this application in detail with reference to the accompanying drawings.

It should be noted that described embodiments are merely some rather than all of embodiments of this application. All other embodiments obtained by a person of ordinary skill in the art based on embodiments of this application without creative efforts shall fall within the protection scope of this application.

The terms used in embodiments of this application are merely for the purpose of illustrating specific embodiments, and are not intended to limit this application. The terms "a", "said" and "the" of singular forms used in embodiments and the appended claims of this application are also intended to include plural forms, unless otherwise specified in the context clearly.

It should be understood that the term "and/or" used in this specification describes only an association relationship between associated objects and indicates that three relationships may exist. For example, A and/or B may indicate the following three cases: Only A exists, both A and B exist, and only B exists. In addition, the character "/" in this specification generally indicates an "or" relationship between the associated objects.

A first aspect of the embodiments of this application provides an electronic device. The electronic device includes but is not limited to a device that can perform signal transmission, like a mobile phone, a computer, a tablet, a headset, or a helmet. The electronic device includes a device body and a chip system installed on the device body. The chip system is configured to implement signal transmission between electronic elements inside the electronic device and between the electronic device and the outside.

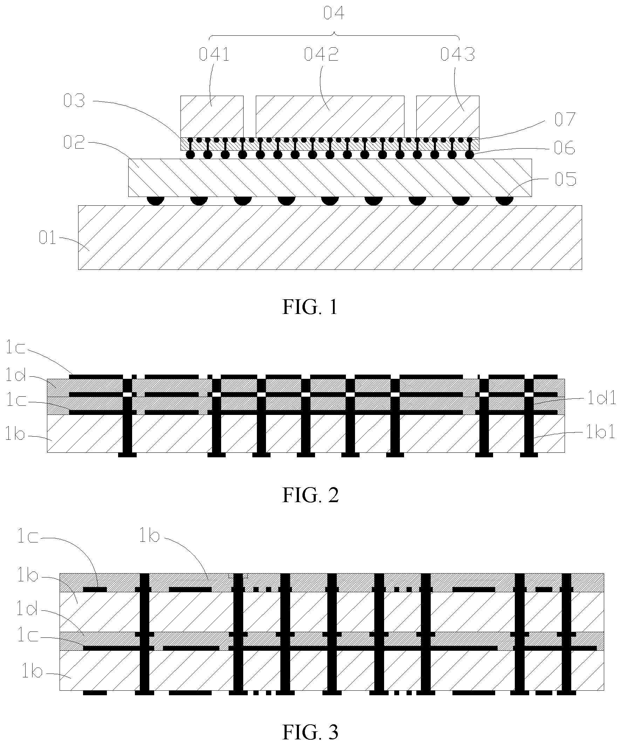

As shown in FIG. 1, the chip system includes a printed circuit board 01, a package substrate 02, an interposer 03, and a plurality of chip dies 04 that are stacked in a thickness direction of the chip system. The package substrate 02 is mounted on the printed circuit board 01. The package substrate 02 is electrically connected to the printed circuit board 01 through a first pin 05. The interposer 03 is mounted on the package substrate 02. The interposer 03 is electrically connected to the package substrate 02 through a second pin 06. The chip dies 04 are mounted on the interposer 03. The plurality of chip dies 04 are electrically connected to the interposer 03 through third pins 07 respectively. As shown in FIG. 1, there are at least two chip dies 04. Three chip dies 04 are used as an example. To be specific, the chip dies 04 include a first chip 041, a second chip 042, and a third chip 043. The first chip 041, the second chip 042, and the third chip 043 are all mounted on the interposer 03. Because a line width of a redistribution layer (RDL) on the interposer 03 is small, the first chip 041, the second chip 042, and the third chip 043 can be closely arranged on a surface of the interposer 03. This reduces a gap between adjacent chip dies 04, and increases a quantity of chip dies 04 that can be disposed in the chip system, thereby improving bandwidth performance of the chip system, and further enhancing working performance of the electronic device.

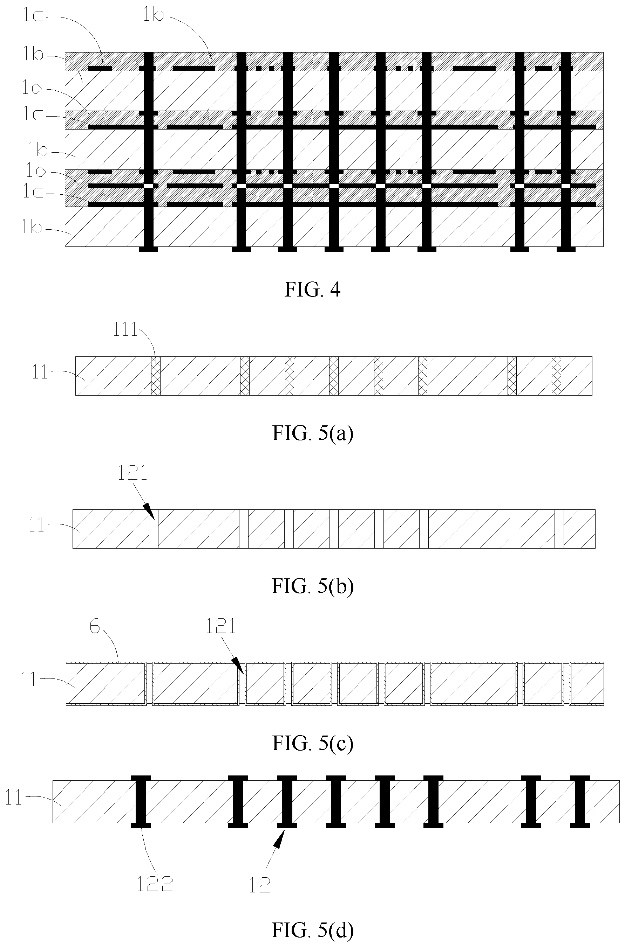

A second aspect of embodiments of this application provides a multi-layer circuit board. The multi-layer circuit board may be used as the package substrate 02 of the chip system, or may be used as the printed circuit board 01 of the chip system. In an embodiment, a stacked structure of the multi-layer circuit board is shown in FIG. 2. The multi-layer circuit board includes a substrate 1b. In a thickness direction of the substrate 1b, a multi-layer structure of a conductive pattern 1c, an insulation layer 1d, and a conductive pattern 1c is disposed on one or two sides of the substrate 1b. A conductive part 1d1 made of conductive paste or solder is disposed on the insulation layer 1d. The conductive pattern 1c is electrically connected to a conductive channel 1b1 on the substrate 1b, and the conductive pattern 1c is electrically connected to the conductive pattern 1c on another side through the conductive part 1d1 on the insulation layer 1d. In other words, the multi-layer circuit board is of a multi-layer composite structure of the substrate 1b, the conductive pattern 1c, the insulation layer 1d, and the conductive pattern 1c. In another embodiment, a stacked structure of the multi-layer circuit board is shown in FIG. 3. The multi-layer circuit board includes a plurality of substrates 1b that are stacked in a thickness direction of the multi-layer circuit board. A conductive pattern 1c is disposed on the substrate 1b. The multi-layer circuit board is electrically connected to an element mounted on the multi-layer circuit board through the conductive pattern 1c. Adjacent substrates 1b are bonded through an insulation layer 1d, and are electrically connected through a conductive channel 1b1 extending in a thickness direction of the substrates 1b. In other words, the multi-layer circuit board is of a multi-layer composite structure of the substrate 1b, the conductive pattern 1c, the insulation layer 1d, the substrate 1b, and the conductive pattern 1c. In another embodiment, a stacked structure of the multi-layer circuit board is shown in FIG. 4. The multi-layer circuit board may include both the multi-layer composite structures in the foregoing two embodiments, to improve structural flexibility of the multi-layer circuit board. For ease of description, the following uses an example in which the multi-layer circuit board is of the multi-layer composite structure of the substrate 1b, the conductive pattern 1c, the insulation layer 1d, the substrate 1b, and the conductive pattern 1c. In this case, the insulation layer 1d is an insulation adhesive film, and is configured to bond and fasten adjacent substrates 1b.

A coefficient of thermal expansion of the substrate 1b matches a coefficient of thermal expansion of the interposer 03. In a process of processing, mounting, transporting, and using the chip system, a risk that the interposer 03 and the substrate 1b have different deformation degrees due to different coefficients of thermal expansion is reduced, thereby reducing a risk that the interposer 03 and the substrate 1b are warped and deformed, are cracked, or even fail to be connected, to improve working stability of the chip system. Specifically, a material of the substrate 1b includes but is not limited to glass, ceramic, sapphire, a resin material, a composite organic material, a composite inorganic material, and the like, provided that the coefficient of thermal expansion of the substrate 1b matches the coefficient of thermal expansion of the interposer 03. The glass material is used as an example. The glass substrate is used to replace the organic substrate, to reduce a signal transmission loss in a working process of the chip system.

For the foregoing multi-layer circuit board, a third aspect of embodiments of this application provides a method for processing a multi-layer circuit board. The method for processing a multi-layer circuit board includes the following steps.

As shown in FIG. 5(a) to FIG. 5(d), a core board 1 is prepared, and as shown in FIG. 5(d), the core board 1 includes a first conductive channel 12 extending in a thickness direction of the core board 1.

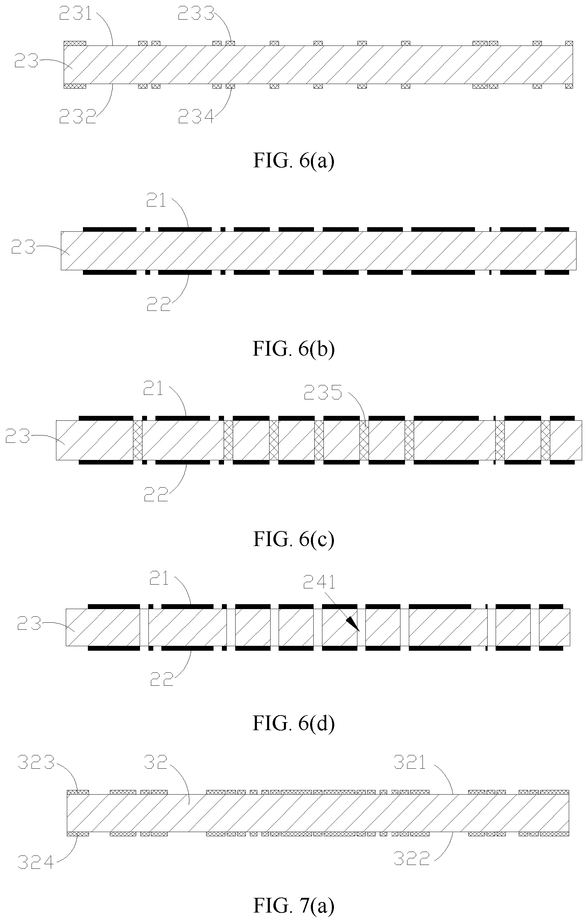

As shown in FIG. 6(a) to FIG. 6(d), a first sub-board 2 is prepared, and as shown in FIG. 6(d), the first sub-board 2 includes a first substrate 23, and a second via 241 extending in a thickness direction of the first substrate 23 is provided in the first substrate 23. The first substrate 23 includes a first surface 231 and a second surface 232 that are disposed opposite to each other in the thickness direction of the first substrate 23. A first conductive pattern 21 is disposed on the first surface 231, and a second conductive pattern 22 is disposed on the second surface 232. A difference between an area proportion of the first conductive pattern 21 on the first surface 231 and an area proportion of the second conductive pattern 22 on the second surface 232 is less than or equal to 50%. The difference may be specifically 0%, 5%, 15%, 20%, 25%, 30%, 35%, 40%, 45%, 50%, or the like. For example, both the first conductive pattern 21 and the second conductive pattern 22 are ground layers or power supply layers. The ground layer is configured to implement grounding of the multi-layer circuit board, and the power supply layer is configured to support power supply distribution and management of an electrical component.

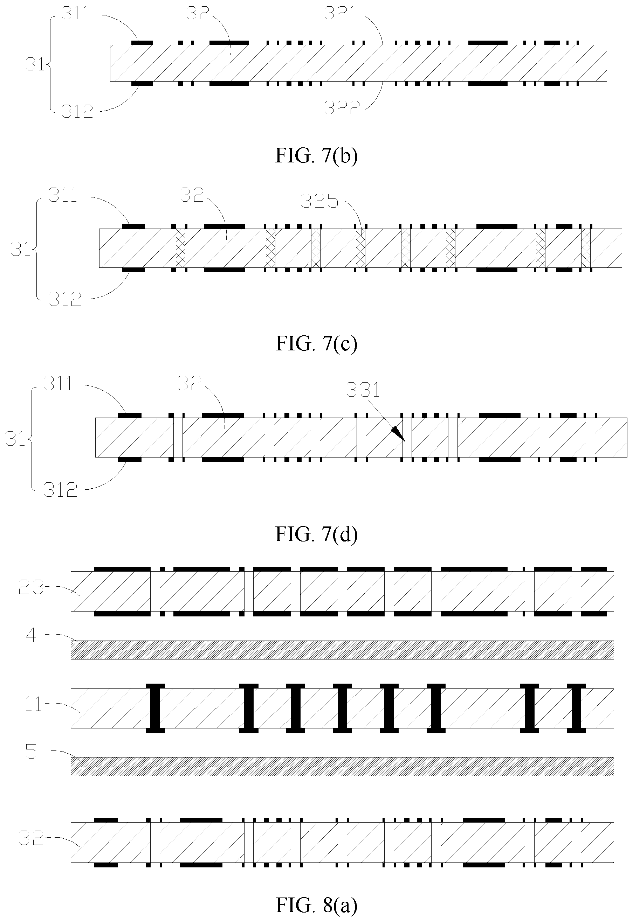

As shown in FIG. 7(a) to FIG. 7(d), a second sub-board 3 is prepared, and as shown in FIG. 7(d), the second sub-board 3 includes a second substrate 32, and a conductive pattern layer 31 and a third via 331 extending in a thickness direction of the second substrate 32 are disposed in the second substrate 32. The second substrate 32 includes a third surface 321 and a fourth surface 322 that are disposed opposite to each other in the thickness direction of the second substrate 32. A third conductive pattern 311 is disposed on the third surface 321, and a fourth conductive pattern 312 is disposed on the fourth surface 322. A difference between an area proportion of the third conductive pattern 311 on the third surface 321 and an area proportion of the fourth conductive pattern 312 on the fourth surface 322 is less than or equal to 50%. The difference may be specifically 0%, 5%, 15%, 20%, 25%, 30%, 35%, 40%, 45%, 50%, or the like. For example, both the third conductive pattern 311 and the fourth conductive pattern 312 are signal layers, and are configured to arrange conducting wires.

As shown in FIG. 8(a), a first insulation layer 4 and a second insulation layer 5 are taken, and the first sub-board 2, the first insulation layer 4, the core board 1, the second insulation layer 5, and the second sub-board 3 are stacked in a thickness direction of the multi-layer circuit board. The first insulation layer 4 is located between the first sub-board 2 and the core board 1, the second insulation layer 5 is located between the core board 1 and the second sub-board 3, the first conductive pattern 21 is located on a side that is of the first sub-board 2 and that is away from the core board 1, and the fourth conductive pattern 312 is located on a side that is of the second sub-board 3 and that is away from the core board 1.

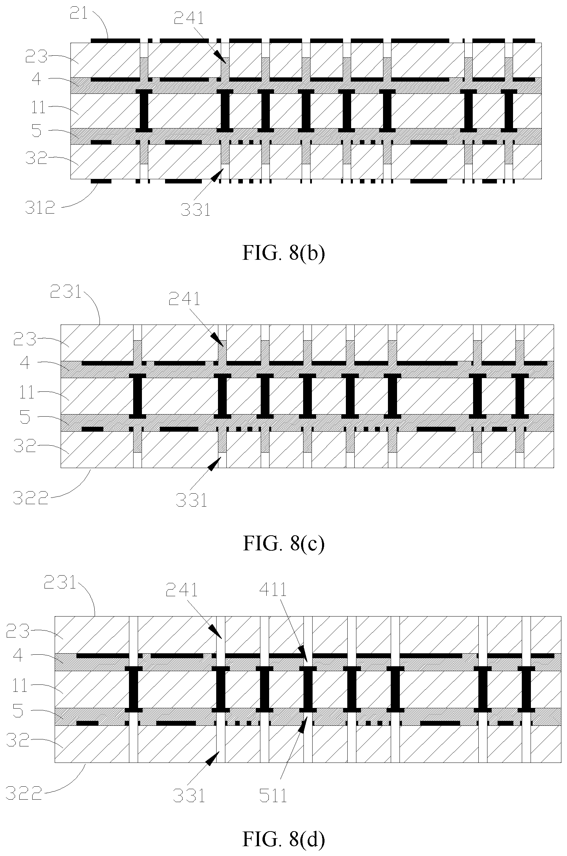

As shown in FIG. 8(b), the first sub-board 2, the first insulation layer 4, the core board 1, the second insulation layer 5, and the second sub-board 3 are fastened through press-fitting. The first sub-board 2 is electrically connected to the second sub-board 3 through a first conductive part 41, a first conductive channel 12, and a second conductive part 51.

The first conductive pattern 21 and the fourth conductive pattern 312 are removed.

The first sub-board 2 is electroplated, to form a fifth conductive pattern on the first surface 231, and fill a second conductive medium 242 into the second via 241 to form a second conductive channel 24, where the fifth conductive pattern, the second conductive channel 24, and the second conductive pattern 22 form a signal transmission line structure. The second sub-board 3 is electroplated, to form a sixth conductive pattern on the fourth surface 322, and fill a third conductive medium 332 into the third via 331 to form a third conductive channel 33, where the sixth conductive pattern, the third conductive channel 33, and the third conductive pattern 311 form a signal transmission line structure. The first insulation layer 4 includes the first conductive part 41, the second insulation layer 5 includes the second conductive part 51, the first conductive channel 12 is electrically connected to the second conductive channel 24 through the first conductive part 41, and the first conductive channel 12 is electrically connected to the third conductive channel 33 through the second conductive part 51.

In this embodiment, the difference between the area proportion of the first conductive pattern 21 on the first surface 231 and the area proportion of the second conductive pattern 22 on the second surface 232 is less than or equal to 50%, so that the first conductive pattern 21 is similar to the second conductive pattern 22. Preferably, the first conductive pattern 21 and the second conductive pattern 22 are symmetrically designed relative to a plane perpendicular to the thickness direction of the multi-layer circuit board, so that mechanical features on two sides of the first sub-board 2 in the thickness direction are similar. This reduces a risk of warping and deformation of the first sub-board 2 in a subsequent processing process, and reduces difficulty in stacking the first sub-board 2 and the core board 1. In addition, this improves accuracy and reliability of an electrical connection between the first sub-board 2 and the core board 1, and an electrical connection between the first sub-board 2 and an element on the first sub-board 2 or the substrate 1b, thereby enhancing working stability and reliability of the chip system and an electronic device.

The difference between the area proportion of the third conductive pattern 311 on the third surface 321 and the area proportion of the fourth conductive pattern 312 on the fourth surface 322 is less than or equal to 50%, so that the third conductive pattern 311 is similar to the fourth conductive pattern 312. Preferably, the third conductive pattern 311 and the fourth conductive pattern 312 are symmetrically designed relative to a plane perpendicular to the thickness direction of the multi-layer circuit board, so that mechanical features on two sides of the second sub-board 3 in the thickness direction are similar. This reduces a risk of warping and deformation of the second sub-board 3 in a subsequent processing process, and reduces difficulty in stacking the second sub-board 3 and the core board 1. In addition, this improves accuracy and reliability of an electrical connection between the second sub-board 3 and the core board 1, and an electrical connection between the second sub-board 3 and an element on the second sub-board 3 or the substrate 1b, thereby increasing a production yield of the multi-layer circuit board and the chip system, and further enhancing working stability and reliability of the chip system and the electronic device. In the process of preparing the first sub-board 2, the first conductive pattern 21 is first removed, and then the fifth conductive pattern and the second conductive channel 24 are prepared. In this way, the fifth conductive pattern, the second conductive channel 24, and the second conductive pattern 22 form a signal transmission line structure, thereby reducing a loss in a signal transmission process of the multi-layer circuit board. Similarly, in the process of preparing the second sub-board 3, the fourth conductive pattern 312 is first removed, and then the sixth conductive pattern and the third conductive channel 33 are prepared. In this way, the sixth conductive pattern, the third conductive channel 33, and the third conductive pattern 311 form a signal transmission line structure, thereby reducing a loss in a signal transmission process of the multi-layer circuit board.

A sequence of the step of preparing the core board 1, the step of preparing the first sub-board 2, and the step of preparing the second sub-board 3 is not specially limited in embodiments. The steps may be performed simultaneously or sequentially. In addition, the step of filling the second conductive medium 242 into the second via 241 may be performed before the step of stacking the first sub-board 2, the first insulation layer 4, the core board 1, the second insulation layer 5, and the second sub-board 3, or may be performed after the step of fastening the first sub-board 2, the first insulation layer 4, the core board 1, the second insulation layer 5, and the second sub-board 3 through press-fitting. Similarly, the step of filling the third conductive medium 332 into the third via 331 may be performed before the step of stacking the first sub-board 2, the first insulation layer 4, the core board 1, the second insulation layer 5, and the second sub-board 3, or may be performed after the step of fastening the first sub-board 2, the first insulation layer 4, the core board 1, the second insulation layer 5, and the second sub-board 3 through press-fitting. In addition, a sequence of the step of filling the second conductive medium 242 into the second via 241 and the step of filling the third conductive medium 332 into the third via 331 is not specially limited in embodiments. This improves flexibility of a processing sequence of the multi-layer circuit board, and the steps may be properly adjusted based on an actual processing situation.

Specifically, in the process of preparing the core board 1, the first conductive channel 12 may be formed by machining a through hole and filling a conductive medium into the through hole, to reduce processing costs; or may be formed by laser etching a through hole and filling a conductive medium into the through hole, to improve processing precision.

In this embodiment, as shown in FIG. 5(a) to FIG. 5(d), the step of preparing the core board 1 includes the following steps.

As shown in FIG. 5(a), a core substrate 11 is taken, and laser induction is performed on the core substrate 11 to form a first phase change channel 111, where an extension direction of the first phase change channel 111 is parallel to a thickness direction of the substrate 1b.

As shown in FIG. 5(b), the core substrate 11 having a phase change channel is etched to form a first via 121.

A first conductive medium 122 is filled into the first via 121 to form the first conductive channel 12.

In this embodiment, the first via 121 is processed through laser induction and etching. This improves precision of a processing position and a processing size of the first via 121, and accuracy of positions at which the core board 1 is electrically connected to the first sub-board 2 and the second sub-board 3, thereby reducing difficulty in stacking and combining the core board 1, the first sub-board 2, and the second sub-board 3. A thickness of the core substrate 11 is 4 to 6 times a diameter of the first via 121, and the thickness of the core substrate 11 is between 100 µm and 200 µm, to increase a quantity and density of first vias 121, thereby improving bandwidth performance of the multi-layer circuit board.

In an embodiment, the step of filling the first conductive medium 122 into the first via 121 includes the following steps: The first conductive medium 122 is placed in the first via 121, where the first conductive medium 122 is solder or conductive paste; and the first via 121 is filled by melting the solder or the conductive paste, to simplify a method for processing the first conductive channel 12, thereby reducing processing costs of the first conductive channel 12.

In another embodiment, as shown in FIG. 5(c) and FIG. 5(d), the step of filling the first conductive medium 122 into the first via 121 includes the following steps.

A metal layer 6 is sputtered on an exposed surface of the core substrate 11 and a side wall of the first via 121.

The exposed surface of the core substrate 11 is covered with photoresist.

Via-filling electroplating is performed on the core substrate 11, to form the first conductive channel 12, where a conductor pattern is formed at two ends of the first conductive channel 12.

The photoresist and the metal layer 6 on the surface of the core substrate 11 are removed.

In this embodiment, the first conductive medium 122 is filled into the first via 121 through via-filling electroplating. This reduces a radial size required for the first via 121, and helps enhance a routing density and a chip signal transmission capability of the multi-layer circuit board, thereby improving bandwidth performance of the multi-layer circuit board and the chip system. In addition, this further helps enhance a conductivity coefficient, a thermal conductivity coefficient, and a through-current capability of the first conductive channel 12, thereby improving signal transmission efficiency, electrical performance, and thermal performance of the multi-layer circuit board, the chip system, and the electronic device. In addition, the via-filling electroplating is suitable for mass production, and a process yield is stable. In addition, the conductor pattern is formed at the two ends of the first conductive channel 12, so that an end part size of the first conductive channel 12 can be easily controlled, to improve processing precision of an end part of the first conductive channel 12, thereby increasing a processing yield of the core board 1. The end part size of the first conductive channel 12 includes but is not limited to a radial size, a thickness, and the like.

Specifically, in an embodiment, the step of preparing the first sub-board 2 includes the following steps.

The first substrate 23 is taken, and the first substrate 23 includes the first surface 231 and the second surface 232 that are disposed opposite to each other in the thickness direction of the first substrate 23.

The first conductive pattern 21 is printed on the first surface 231, and the second conductive pattern 22 is printed on the second surface 232.

In this embodiment, the first conductive pattern 21 and the second conductive pattern 22 are processed through printing. This simplifies a processing manner of the first sub-board 2, thereby helping reduce processing costs of the first sub-board 2.

In another embodiment, as shown in FIG. 6(a) and FIG. 6(b), the step of preparing the first sub-board 2 includes the following steps.

The first substrate 23 is taken, and a metal layer 6 is sputtered on the first surface 231 and the second surface 232.

The first surface 231 is covered with first photoresist 233, and the second surface 232 is covered with second photoresist 234.

Photolithography is performed on the first surface 231 to form a first pattern, and photolithography is performed on the second surface 232 to form a second pattern.

The first pattern and the second pattern are electroplated to form the first conductive pattern 21 and the second conductive pattern 22.

The first photoresist 233, the second photoresist 234, and the metal layer 6 are removed.

In this embodiment, the first conductive pattern 21 and the second conductive pattern 22 are processed through photolithography and electroplating. This improves accuracy of parameters such as shapes, positions, and sizes of the first conductive pattern 21 and the second conductive pattern 22, thereby increasing a processing yield of the first sub-board 2.

More specifically, the step of preparing the first sub-board 2 further includes the following step: The second via 241 is processed in the first sub-board 2. The step of processing the second via 241 in the first sub-board 2 may be performed before or after the step of processing the first conductive pattern 21 and the second conductive pattern 22.

In an embodiment, the first sub-board 2 is drilled through machining to form the second via 241, thereby simplifying a processing manner of the first sub-board 2, and reducing processing costs.

In another embodiment, as shown in FIG. 6(c) and FIG. 6(d), the step of processing the second via 241 in the first sub-board 2 includes the following steps.

Laser induction is performed on the first substrate 23 to form a second phase change channel 235, where an extension direction of the second phase change channel 235 is parallel to the thickness direction of the substrate 1b.

The first substrate 23 having two phase change channels is etched to form the second via 241.

In this embodiment, the second via 241 is processed through laser induction and etching. This improves precision of a processing position and a processing size of the second via 241, thereby enhancing accuracy of a position at which the first sub-board 2 is electrically connected to the core board 1, and further reducing difficulty in stacking and combining the first sub-board 2 and the core board 1. A thickness of the first substrate 23 is 4 to 6 times a diameter of the second via 241, and the thickness of the first substrate 23 is between 100 µm and 200 µm, to increase a quantity and density of the second vias 241, thereby improving bandwidth performance of the multi-layer circuit board.

More specifically, the step of electroplating the first sub-board 2 includes the following steps.

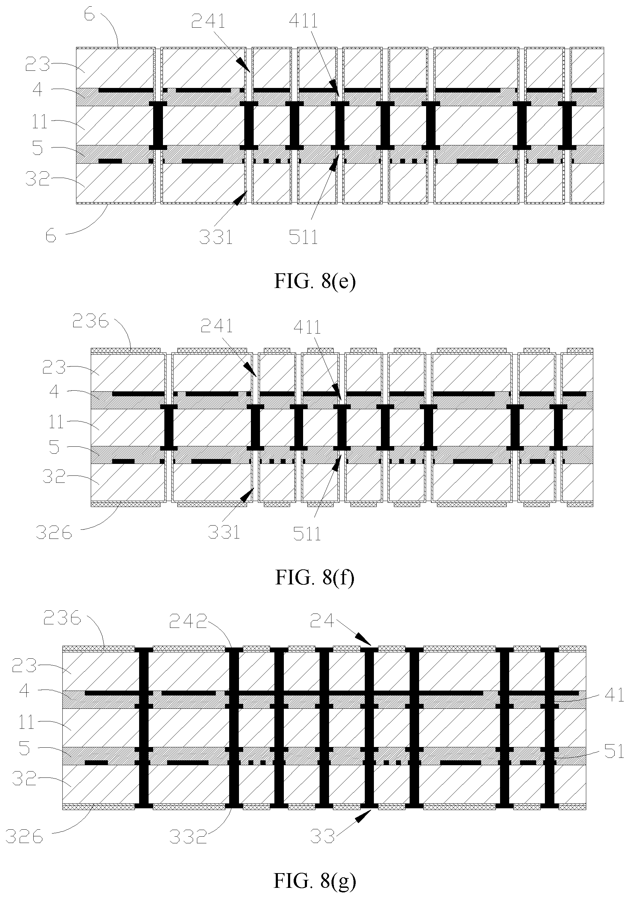

As shown in FIG. 8(e), metal 6 is sputtered on the first surface 231 and a side wall of the second via 241.

As shown in FIG. 8(f), the first surface 231 is covered with fifth photoresist 236.

Photolithography is performed on the first surface 231 to form a fifth pattern.

As shown in FIG. 8(g), the fifth pattern and the second via 241 are electroplated, so that the second conductive medium 242 covers the fifth pattern and is filled into the second via 241, to form the fifth conductive pattern and the second conductive channel 24.

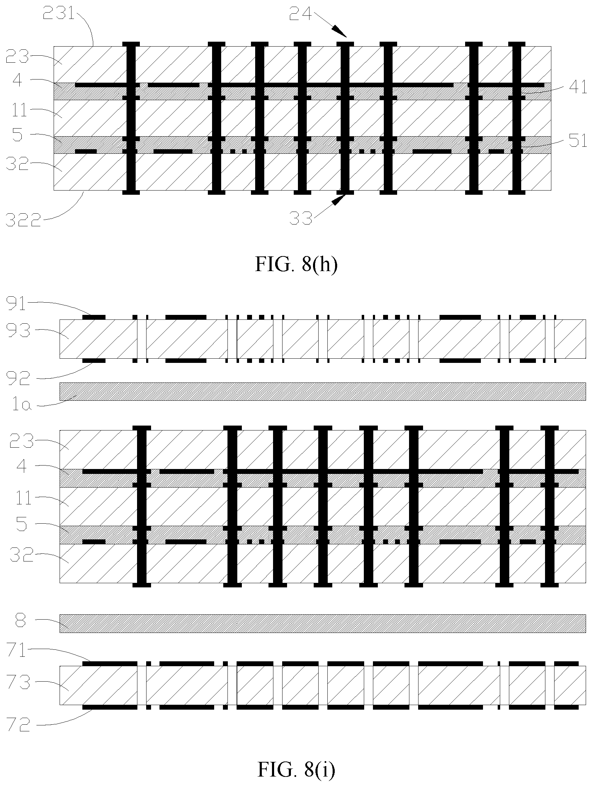

As shown in FIG. 8(h), the fifth photoresist 236 and the metal layer 6 on the surface of the first substrate 23 are removed.

In this embodiment, the second conductive medium 242 is filled into the second via 241 through via-filling electroplating, to reduce a radial size required for the second via 241. This helps enhance a routing density and a chip signal transmission capability of the multi-layer circuit board. In addition, this helps increase a conductivity coefficient and a thermal conductivity coefficient of the second conductive channel 24, thereby helping improve electrical performance and thermal performance of the multi-layer circuit board, the chip system, and the electronic device. In addition, the via-filling electroplating is suitable for mass production, and a process yield is stable. The fifth conductive pattern and the second conductive channel 24 are electroplated and processed simultaneously, thereby simplifying processing operations and a processing periodicity of the first sub-board 2.

Specifically, in an embodiment, the step of preparing the second sub-board 3 includes the following steps.

The second substrate 32 is taken, and the second substrate 32 includes the third surface 321 and the fourth surface 322 that are disposed opposite to each other in the thickness direction of the second substrate 32.

The third conductive pattern 311 is printed on the third surface 321, and the fourth conductive pattern 312 is printed on the fourth surface 322.

In this embodiment, the third conductive pattern 311 and the fourth conductive pattern 312 are processed through printing. This simplifies a processing manner of the second sub-board 3, thereby helping reduce processing costs of the second sub-board 3.

In another embodiment, as shown in FIG. 7(a) and FIG. 7(b), the step of preparing the second sub-board 3 includes the following steps.

The second substrate 32 is taken, and a metal layer 6 is sputtered on the third surface 321 and the fourth surface 322.

The third surface 321 is covered with third photoresist 323, and the fourth surface 322 is covered with fourth photoresist 324.

Photolithography is performed on the third surface 321 to form a third pattern, and photolithography is performed on the fourth surface 322 to form a fourth pattern.

The third pattern and the fourth pattern are electroplated to form the third conductive pattern 311 and the fourth conductive pattern 312.

The third photoresist 323, the fourth photoresist 324, and the metal layer 6 are removed.

In this embodiment, the third conductive pattern 311 and the fourth conductive pattern 312 are processed through photolithography and electroplating. This improves accuracy of parameters such as shapes, positions, and sizes of the third conductive pattern 311 and the fourth conductive pattern 312, thereby increasing a processing yield of the second sub-board 3.

More specifically, the step of preparing the second sub-board 3 further includes the following step: The third via 331 is processed in the second sub-board 3. The step of processing the third via 331 in the second sub-board 3 may be performed before or after the step of processing the third conductive pattern 311 and the fourth conductive pattern 312.

In an embodiment, the second sub-board 3 is drilled through machining to form the third via 331, thereby simplifying a processing manner of the second sub-board 3, and reducing processing costs.

In another embodiment, as shown in FIG. 7(c) and FIG. 7(d), the step of preparing the second sub-board 3 includes the following steps.

Laser induction is performed on the second substrate 32 to form a third phase change channel 325, where an extension direction of the third phase change channel 325 is parallel to the thickness direction of the substrate 1b.

The second substrate 32 having three phase change channels is etched to form the third via 331.

In this embodiment, the third via 331 is processed through laser induction and etching. This improves precision of a processing position and a processing size of the third via 331, and accuracy of a position at which the second sub-board 3 is electrically connected to the core board 1, thereby reducing difficulty in stacking and combining the second sub-board 3 and the core board 1. A thickness of the second substrate 32 is 4 to 6 times a diameter of the third via 331, and the thickness of the second substrate 32 is between 100 µm and 200 µm, to increase a quantity and density of third vias 331, thereby improving bandwidth performance of the multi-layer circuit board.

More specifically, the step of electroplating the second sub-board 3 includes the following steps.

As shown in FIG. 8(e), a metal layer 6 is sputtered on the fourth surface 322 and a side wall of the third via 331.

As shown in FIG. 8(f), the fourth surface 322 is covered with sixth photoresist 326.

Photolithography is performed on the fourth surface 322 to form a sixth pattern.

As shown in FIG. 8(g), the sixth pattern and the third via 331 are electroplated, so that the third conductive medium 332 covers the sixth pattern and is filled into the third via 331, to form the sixth conductive pattern 1c and the third conductive channel 33.

As shown in FIG. 8(h), the sixth photoresist 326 and the metal layer 6 are removed.

In this embodiment, the third conductive medium 332 is filled into the third via 331 through via-filling electroplating. This reduces a radial size required for the third via 331, and helps enhance a routing density and a chip signal transmission capability of the multi-layer circuit board, thereby improving bandwidth performance of the multi-layer circuit board and the chip system. In addition, this further helps increase a conductivity coefficient, a thermal conductivity coefficient, and a through-current capability of the third conductive channel 33, thereby improving signal transmission efficiency, electrical performance, and thermal performance of the multi-layer circuit board and the chip system. The via-filling electroplating is suitable for mass production, and a process yield is stable. The sixth conductive pattern 1c and the third conductive channel 33 are electroplated and processed simultaneously, thereby simplifying processing operations and a processing periodicity of the first sub-board 2.

In any one of the foregoing embodiments, the first conductive part 41 on the first insulation layer 4 and the second conductive part 51 on the second insulation layer 5 are processed by using the foregoing via-filling electroplating process. To be specific, as shown in FIG. 8(a) to FIG. 8(g), the step of stacking the first sub-board 2, the first insulation layer 4, the core board 1, the second insulation layer 5, and the second sub-board 3 includes the following steps.

As shown in FIG. 8(a), the first insulation layer 4 and the second insulation layer 5 are respectively placed on two sides of the core board 1 in the thickness direction of the core board 1, the first sub-board 2 is placed on a side that is of the first insulation layer 4 and that is away from the core board 1 in the thickness direction of the core board 1, and the second sub-board 3 is placed on a side that is of the second insulation layer 5 and that is away from the core board 1.

After the step of fastening the first sub-board 2, the first insulation layer 4, the core board 1, the second insulation layer 5, and the second sub-board 3 through press-fitting, the method for processing a multi-layer circuit board includes the following steps.

As shown in FIG. 8(d), a first through hole 411 is processed in the first insulation layer 4, and a second through hole 511 is processed in the second insulation layer 5. The first through hole 411 penetrates the first insulation layer 4 in a thickness direction of the first insulation layer 4, and the second through hole 511 penetrates the second insulation layer 5 in a thickness direction of the second insulation layer 5.

A metal layer 6 is sputtered on a side wall of the first through hole 411 and a side wall of the second through hole 511.

Via-filling electroplating is performed on the first through hole 411 to form the first conductive part 41, and via-filling electroplating is performed on the second through hole 511 to form the second conductive part 51.

In this embodiment, the first conductive part 41 and the second conductive part 51 are processed through via-filling electroplating, to reduce radial sizes required for the first conductive part 41 and the second conductive part 51. This helps enhance a routing density and a chip signal transmission capability of the multi-layer circuit board. In addition, this helps increase conductivity coefficients and thermal conductivity coefficients of the first conductive part and the second conductive part, thereby helping improve electrical performance and thermal performance of the multi-layer circuit board, the chip system, and the electronic device. The via-filling electroplating is suitable for mass production, and a process yield is stable.

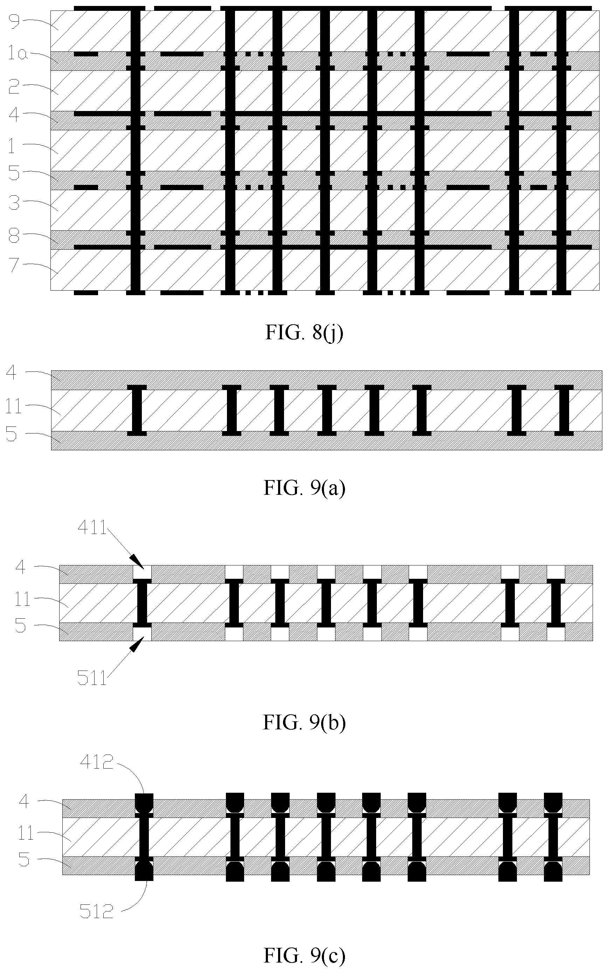

In another embodiment, the first conductive part 41 on the first insulation layer 4 and the second conductive part 51 on the second insulation layer 5 are formed by filling the solar or conductive paste. To be specific, as shown in FIG. 9(a) to FIG. 9(d), the step of stacking the first sub-board 2, the first insulation layer 4, the core board 1, the second insulation layer 5, and the second sub-board 3 includes the following steps.

As shown in FIG. 9(a), the first insulation layer 4 and the second insulation layer 5 are respectively placed on two sides of the core board 1 in the thickness direction of the core board 1.

As shown in FIG. 9(b), a first through hole 411 is processed in the first insulation layer 4, and a second through hole 511 is processed in the second insulation layer 5. The first through hole 411 penetrates the first insulation layer 4 in a thickness direction of the first insulation layer 4, and the second through hole 511 penetrates the second insulation layer 5 in a thickness direction of the second insulation layer 5.

As shown in FIG. 9(c), the fourth conductive medium 412 is placed in the first through hole 411, and the fifth conductive medium 512 is placed in the second through hole 511. The fourth conductive medium 412 is solder or conductive paste, and the fifth conductive medium 512 is solder or conductive paste.

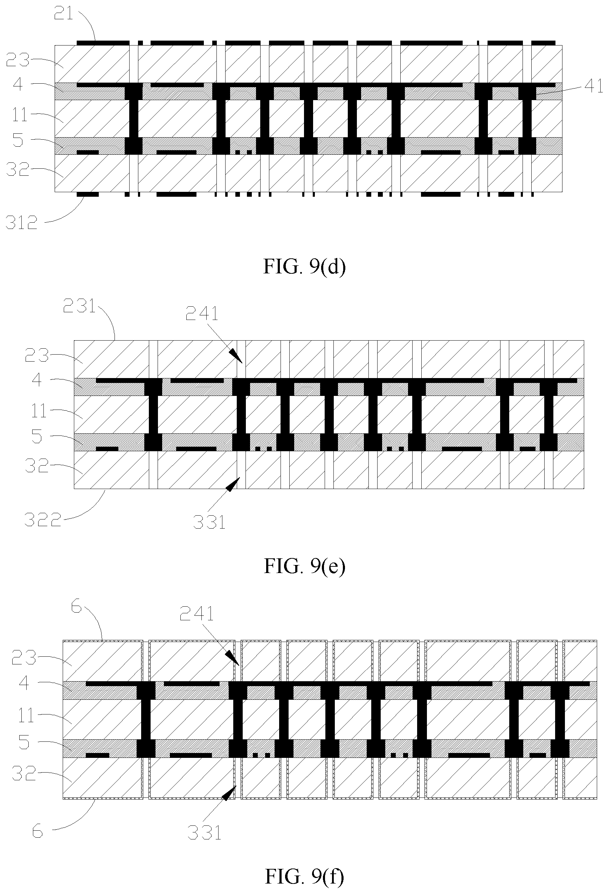

As shown in FIG. 9(d), the first sub-board 2 is placed on a side that is of the first insulation layer 4 and that is away from the core board 1 in the thickness direction of the core board 1, and the second sub-board 3 is placed on a side that is of the second insulation layer 5 and that is away from the core board 1.

In this embodiment, the first through hole 411 and the second through hole 511 are filled by melting the solder or the conductive paste, to simplify a method for processing the first through hole 411 and the second through hole 511, thereby reducing processing costs of the first insulation layer 4 and the second insulation layer 5, and further reducing processing costs of the multi-layer circuit board, the chip system, and the electronic device.

When the multi-layer circuit board further includes a third sub-board 7 that is disposed through stacking, the method for processing a multi-layer circuit board further includes the following steps.

The third sub-board 7 shown in FIG. 8(i) is prepared according to the steps of preparing the first sub-board 2 and the second sub-board 3. The third sub-board 7 includes a third substrate, where the third substrate includes a fourth via extending in a thickness direction of the third substrate. The third sub-board 7 includes a fifth surface and a sixth surface that are disposed opposite to each other in a thickness direction of the third sub-board 7. A seventh conductive pattern 71 is disposed on the fifth surface, and an eighth conductive pattern 72 is disposed on the sixth surface. A difference between an area proportion of the seventh conductive pattern 71 on the fifth surface and an area proportion of the eighth conductive pattern 72 on the sixth surface is less than or equal to 50%. The difference may be specifically 0%, 5%, 15%, 20%, 25%, 30%, 35%, 40%, 45%, 50%, or the like. For example, both the seventh conductive pattern 71 and the eighth conductive pattern 72 are ground layers or power supply layers, in other words, the seventh conductive pattern 71 is similar to the eighth conductive pattern 72. Preferably, the seventh conductive pattern 71 and the eighth conductive pattern 72 are symmetrically designed relative to a plane perpendicular to the thickness direction of the multi-layer circuit board.

A third insulation layer 8 is taken, and the third insulation layer 8 and the third sub-board 7 are placed on a side that is of the second sub-board 3 and that is away from the core board 1 in a thickness direction of the second sub-board 3, where the third insulation layer 8 is located between the second sub-board 3 and the third sub-board 7.

The second sub-board 3 and the third sub-board 7 are fastened through press-fitting.

The eighth conductive pattern 72 is removed.

The third sub-board 7 is electroplated, to form an eleventh conductive pattern on the sixth surface, and fill a sixth conductive medium into the fourth via to form the fourth conductive channel 1b1. The eleventh conductive pattern, the fourth conductive channel 1b1, and the seventh conductive pattern 71 form a signal transmission line structure. The third sub-board 7 is electrically connected to the second sub-board 3 through the fourth conductive channel 1b1 and the third conductive part on the third insulation layer 8.

In addition/alternatively, when the multi-layer circuit board further includes a fourth sub-board 9 that is disposed through stacking, the method for processing a multi-layer circuit board further includes the following steps.

The fourth sub-board 9 shown in FIG. 8(i) is prepared according to the steps of preparing the first sub-board 2 and the second sub-board 3. The fourth sub-board 9 includes a plurality of fourth substrates, where the fourth substrate includes a fifth via extending in a thickness direction of the fourth substrate. The fourth substrate includes a seventh surface and an eighth surface that are disposed opposite to each other in the thickness direction of the fourth substrate. A ninth conductive pattern 91 is disposed on the seventh surface, and a tenth conductive pattern 92 is disposed on the eighth surface. A difference between an area proportion of the ninth conductive pattern 91 on the seventh surface and an area proportion of the tenth conductive pattern 92 on the eighth surface is less than or equal to 50%. The difference may be specifically 0%, 5%, 15%, 20%, 25%, 30%, 35%, 40%, 45%, 50%, or the like. For example, both the ninth conductive pattern 91 and the tenth conductive pattern 92 are signal layers, in other words, the ninth conductive pattern 91 is similar to the tenth conductive pattern 92. Preferably, the ninth conductive pattern 91 and the tenth conductive pattern 92 are symmetrically designed relative to a plane perpendicular to the thickness direction of the multi-layer circuit board.

A fourth insulation layer 1a is taken, and the fourth insulation layer 1a and the fourth sub-board 9 are placed on a side that is of the first sub-board 2 and that is away from the core board 1 in a thickness direction of the first sub-board 2, where the fourth insulation layer 1a is located between the fourth sub-board 9 and the first sub-board 2.

The fourth sub-board 9 and the first sub-board 2 are fastened through press-fitting.

The ninth conductive pattern 91 is removed.

The fourth sub-board 9 is electroplated, to form a twelfth conductive pattern on the seventh surface, and fill a seventh conductive medium into the fifth via to form a fifth conductive channel 1b1. The twelfth conductive pattern, the fifth conductive channel 1b1, and the tenth conductive pattern 92 form a signal transmission line structure. The fourth sub-board 9 is electrically connected to the first sub-board 2 through the fifth conductive channel 1b1, the fourth conductive part on the fourth insulation layer 1a, and the second conductive channel 24.

In this embodiment, the multi-layer circuit board further includes the third sub-board 7 and the fourth sub-board 9, so that a quantity of stacked substrates 1b on the multi-layer circuit board is increased, to meet a signal transmission requirement of a chip system with higher performance. The difference between the area proportion of the seventh conductive pattern 71 and the area proportion of the eighth conductive pattern 72 and the difference between the area proportion of the ninth conductive pattern 91 and the area proportion of the tenth conductive pattern 92 are less than or equal to 50%. In this way, the third sub-board and the fourth sub-board 9 have similar mechanical features on two sides, thereby reducing a risk of deformation of the third sub-board 7 and the fourth sub-board 9.

In addition, the multi-layer circuit board may further include a fifth sub-board, a sixth sub-board, a seventh sub-board, and the like. A quantity of stacked substrates 1b on the multi-layer circuit board is not specially limited in this application.

The substrate 1b like the core substrate 11, the first substrate 23, the second substrate 32, the third substrate, and the fourth substrate in any one of the foregoing embodiments is formed by processing a plate-like substrate, to be specific, the plate-like substrate is cut, so that a length, width, and thickness of the cut plate-like substrate all meet use requirements of the multi-layer circuit board.

In conclusion, in an embodiment, a method for processing a multi-layer circuit board includes the following steps.

As shown in FIG. 5(a), a core substrate 11 is taken, and laser induction is performed on the core substrate 11 to form a first phase change channel 111, where an extension direction of the first phase change channel 111 is parallel to a thickness direction of the substrate 1b.

As shown in FIG. 5(b), the core substrate 11 having a phase change channel is etched to form a first via 121.

As shown in FIG. 5(c), a metal 6 is sputtered and electroplated on an exposed surface of the core substrate 11 and a side wall of the first via 121.

The exposed surface of the core substrate 11 is covered with photoresist.

As shown in FIG. 5(d), via-filling electroplating is performed on the core substrate 11, to form a first conductive channel 12, where a conductor pattern is formed at two ends of the first conductive channel 12.

The photoresist and the metal layer 6 on the surface of the core substrate 11 are removed.

As shown in FIG. 6(a), a first substrate 23 is taken, and a metal layer 6 is sputtered on the first surface 231 and the second surface 232.

The first surface 231 is covered with first photoresist 233, and the second surface 232 is covered with second photoresist 234.

Photolithography is performed on the first surface 231 to form a first pattern, and photolithography is performed on the second surface to form a second pattern.

The first pattern and the second pattern are electroplated to form a first conductive pattern 21 and a second conductive pattern 22, where a difference between an area proportion of the first conductive pattern 21 on the first surface 231 and an area proportion of the second conductive pattern 22 on the second surface 232 is less than or equal to 50%.

The first photoresist 233, the second photoresist 234, and the metal layer 6 are removed.

As shown in FIG. 6(c), laser induction is performed on the first substrate 23 to form a second phase change channel 235, where an extension direction of the second phase change channel 235 is parallel to the thickness direction of the substrate 1b.

As shown in FIG. 6(d), the first substrate 23 having two phase change channels is etched to form a second via 241.

As shown in FIG. 7(a), the second substrate 32 is taken, and a metal layer 6 is electroplated on the third surface 321 and the fourth surface 322.

The third surface 321 is covered with third photoresist 323, and the fourth surface 322 is covered with fourth photoresist 324.

Photolithography is performed on the third surface 321 to form a third pattern, and photolithography is performed on the second surface 232 to form a fourth pattern.

The third pattern and the fourth pattern are electroplated to form a third conductive pattern 311 and a fourth conductive pattern 312, where a difference between an area proportion of the third conductive pattern 311 on the third surface 321 and an area proportion of the fourth conductive pattern 312 on the fourth surface 322 is less than or equal to 50%.

The third photoresist 323, the fourth photoresist 324, and the metal layer 6 are removed.

As shown in FIG. 7(c), laser induction is performed on the second substrate 32 to form a third phase change channel 325, where an extension direction of the third phase change channel 325 is parallel to the thickness direction of the substrate 1b.

As shown in FIG. 7(d), the second substrate 32 having three phase change channels is etched to form a third via 331.

As shown in FIG. 8(a), a first insulation layer 4 and a second insulation layer 5 are taken, and the first sub-board 2, the first insulation layer 4, the core board 1, the second insulation layer 5, and the second sub-board 3 are stacked in a thickness direction of the multi-layer circuit board. The first insulation layer 4 is located between the first sub-board 2 and the core board 1, the second insulation layer 5 is located between the core board 1 and the second sub-board 3, the first conductive pattern 21 is located on a side that is of the first sub-board 2 and that is away from the core board 1, and the fourth conductive pattern 312 is located on a side that is of the second sub-board 3 and that is away from the core board 1.

As shown in FIG. 8(b), the first sub-board 2, the first insulation layer 4, the core board 1, the second insulation layer 5, and the second sub-board 3 are fastened through press-fitting.

As shown in FIG. 8(c), the first conductive pattern 21 and the fourth conductive pattern 312 are removed.

As shown in FIG. 8(d), a first through hole 411 is processed in the first insulation layer 4, and a second through hole 511 is processed in the second insulation layer 5. The first through hole 411 penetrates the first insulation layer 4 in a thickness direction of the first insulation layer 4, and the second through hole 511 penetrates the second insulation layer 5 in a thickness direction of the second insulation layer 5.

As shown in FIG. 8(e), a metal layer 6 is sputtered on the first surface 231, the second via 241, the first through hole 411, the fourth surface 322, the third via 331, and a side wall of the second through hole 511.

As shown in FIG. 8(f), the first surface 231 is covered with fifth photoresist 236, and the fourth surface 322 is covered with sixth photoresist 326.

Photolithography is performed on the first surface 231 to form a fifth pattern, and photolithography is performed on the fourth surface 322 to form a sixth pattern.

As shown in FIG. 8(g), the first sub-board 2 and the first insulation layer 4 are electroplated to form a fifth conductive pattern, a second conductive channel 24, and a first conductive part 41, where the fifth conductive pattern, the second conductive channel 24, and the second conductive pattern 22 form a signal transmission line structure; and the second sub-board 3 and the second insulation layer 5 are electroplated to form a sixth conductive pattern, a third conductive channel 33, and a second conductive part 51, where the sixth conductive pattern, the third conductive channel 33, and the third conductive pattern 311 form a signal transmission line structure. The fifth conductive pattern, the second conductive channel 24, and the second conductive pattern 22 form a signal transmission line structure, and the sixth conductive pattern, the third conductive channel 33, and the third conductive pattern 311 form a signal transmission line structure.

As shown in FIG. 8(h), the fifth photoresist 236, the sixth photoresist 326, and the metal layer 6 are removed.

A third sub-board 7 and a fourth sub-board 9 are prepared according to steps of preparing the first sub-board 2 and the second sub-board 3. The third sub-board 7 includes a fourth via extending in a thickness direction of the third sub-board 7, and the third sub-board 7 includes a seventh conductive pattern 71 and an eighth conductive pattern 72 that are disposed opposite to each other in the thickness direction of the third sub-board 7. A difference between an area proportion of the seventh conductive pattern 71 on the fifth surface and an area proportion of the eighth conductive pattern 72 on the sixth surface is less than or equal to 50%. The fourth sub-board 9 includes a fifth via extending in a thickness direction of the fourth sub-board 9, and the fourth sub-board 9 includes a ninth conductive pattern 91 and a tenth conductive pattern 92 that are disposed opposite to each other in the thickness direction of the fourth sub-board 9. A difference between an area proportion of the ninth conductive pattern 91 on the seventh surface and an area proportion of the tenth conductive pattern 92 on the eighth surface is less than or equal to 50%.

As shown in FIG. 8(i), a third insulation layer 8 is taken, and the third insulation layer 8 and the third sub-board 7 are placed on a side that is of the second sub-board 3 and that is away from the core board 1 in a thickness direction of the second sub-board 3, where the third insulation layer 8 is located between the second sub-board 3 and the third sub-board 7.

A fourth insulation layer 1a is taken, and the fourth insulation layer 1a and the fourth sub-board 9 are placed on a side that is of the first sub-board 2 and that is away from the core board 1 in a thickness direction of the first sub-board 2, where the fourth insulation layer 1a is located between the fourth sub-board 9 and the first sub-board 2.

The third sub-board 7, the third insulation layer 8, and the second sub-board 3 are fastened through press-fitting, and the fourth sub-board 9, the fourth insulation layer 1a, and the first sub-board 2 are fastened through press-fitting.

A multi-layer circuit board having five layers of stacked and combined substrates 1b shown in FIG. 8(j) is formed by performing the steps shown in FIG. 8(c) to FIG. 8(h).

In conclusion, in another embodiment, a method for processing a multi-layer circuit board includes the following steps.

As shown in FIG. 5(a), a core substrate 11 is taken, and laser induction is performed on the core substrate 11 to form a first phase change channel 111, where an extension direction of the first phase change channel 111 is parallel to a thickness direction of the substrate 1b.

As shown in FIG. 5(b), the core substrate 11 having a phase change channel is etched to form a first via 121.

As shown in FIG. 5(c), a metal layer 6 is sputtered on an exposed surface of the core substrate 11 and a side wall of the first via 121.

The exposed surface of the core substrate 11 is covered with photoresist.

As shown in FIG. 5(d), via-filling electroplating is performed on the core substrate 11 to form a first conductive channel 12, where a conductor pattern is formed at two ends of the first conductive channel 12.

The photoresist and the metal layer 6 on the surface of the core substrate 11 are removed.

As shown in FIG. 6(a), a first substrate 23 is taken, and a metal layer 6 is sputtered on the first surface 231 and the second surface 232.

The first surface 231 is covered with first photoresist 233, and the second surface 232 is covered with second photoresist 234.

Photolithography is performed on the first surface 231 to form a first pattern, and photolithography is performed on the second surface to form a second pattern.

The first pattern and the second pattern are electroplated to form a first conductive pattern 21 and a second conductive pattern 22, where a difference between an area proportion of the first conductive pattern 21 on the first surface 231 and an area proportion of the second conductive pattern 22 on the second surface 232 is less than or equal to 50%.

The first photoresist 233, the second photoresist 234, and the metal layer 6 are removed.

As shown in FIG. 6(c), laser induction is performed on the first substrate 23 to form a second phase change channel 235, where an extension direction of the second phase change channel 235 is parallel to the thickness direction of the substrate 1b.

As shown in FIG. 6(d), the first substrate 23 having two phase change channels is etched to form a second via 241.

As shown in FIG. 7(a), a second substrate 32 is taken, and a metal layer 6 is sputtered on a third surface 321 and a fourth surface 322.

The third surface 321 is covered with third photoresist 323, and the fourth surface 322 is covered with fourth photoresist 324.

Photolithography is performed on the third surface 321 to form a third pattern, and photolithography is performed on the second surface 232 to form a fourth pattern.

The third pattern and the fourth pattern are electroplated to form a third conductive pattern 311 and a fourth conductive pattern 312, where a difference between an area proportion of the third conductive pattern 311 on the third surface 321 and an area proportion of the fourth conductive pattern 312 on the fourth surface 322 is less than or equal to 50%.

The third photoresist 323, the fourth photoresist 324, and the metal layer 6 are removed.

As shown in FIG. 7(c), laser induction is performed on the second substrate 32 to form a third phase change channel 325, where an extension direction of the third phase change channel 325 is parallel to the thickness direction of the substrate 1b.

As shown in FIG. 7(d), the second substrate 32 having three phase change channels is etched to form a third via 331.

As shown in FIG. 9(a), a first insulation layer 4 and a second insulation layer 5 are taken, and the first insulation layer 4, the core board 1, and the second insulation layer 5 are stacked in a thickness direction of the multi-layer circuit.

As shown in FIG. 9(b), a first through hole 411 is processed in the first insulation layer 4, and a second through hole 511 is processed in the second insulation layer 5.

As shown in FIG. 9(c), solder or conductive paste is placed in the first through hole 411 and the second through hole 511.

As shown in FIG. 9(d), the first sub-board 2 is placed on a side that is of the first insulation layer 4 and that is away from the core board 1, the second sub-board 3 is placed on a side that is of the second insulation layer 5 and that is away from the core board 1, and the first sub-board 2, the first insulation layer 4, the core board 1, the second insulation layer 5, and the second sub-board 3 are fastened through press-fitting.

As shown in FIG. 9(e), the first conductive pattern 21 and the fourth conductive pattern 312 are removed.

As shown in FIG. 9(f), a metal layer 6 is sputtered on the first surface 231, the second via 241, the fourth surface 322, and a side wall of the third via 331.

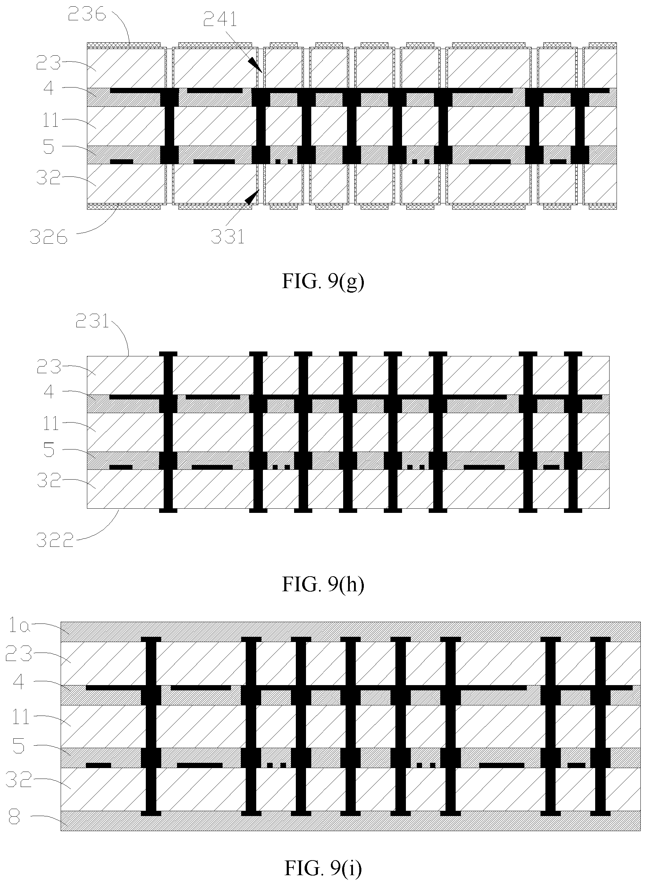

As shown in FIG. 9(g), the first surface 231 is covered with fifth photoresist 236, and the fourth surface 322 is covered with sixth photoresist 326.

Photolithography is performed on the first surface 231 to form a fifth pattern, and photolithography is performed on the fourth surface 322 to form a sixth pattern.

As shown in FIG. 9(h), the first sub-board 2 is electroplated to form a fifth conductive pattern and a second conductive channel 24, where the fifth conductive pattern, the second conductive channel 24, and the second conductive pattern 22 form a signal transmission line structure; and the second sub-board 3 is electroplated to form a sixth conductive pattern and a third conductive channel 33, where the sixth conductive pattern, the third conductive channel 33, and the second conductive pattern 22 form a signal transmission line structure.

The fifth photoresist 236, the sixth photoresist 326, and the metal layer 6 are removed.

A third sub-board 7 and a fourth sub-board 9 are prepared according to steps of preparing the first sub-board 2 and the second sub-board 3. The third sub-board 7 includes a fourth via extending in a thickness direction of the third sub-board 7, and the third sub-board 7 includes a seventh conductive pattern 71 and an eighth conductive pattern 72 that are disposed opposite to each other in the thickness direction of the third sub-board 7. A difference between an area proportion of the seventh conductive pattern 71 on the fifth surface and an area proportion of the eighth conductive pattern 72 on the sixth surface is less than or equal to 50%. The fourth sub-board 9 includes a fifth via extending in a thickness direction of the fourth sub-board 9, and the fourth sub-board 9 includes a ninth conductive pattern 91 and a tenth conductive pattern 92 that are disposed opposite to each other in the thickness direction of the fourth sub-board 9. A difference between an area proportion of the ninth conductive pattern 91 on the seventh surface and an area proportion of the tenth conductive pattern 92 on the eighth surface is less than or equal to 50%.

As shown in FIG. 9(i), a third insulation layer 8 is taken, and the third insulation layer 8 and the third sub-board 7 are placed on a side that is of the second sub-board 3 and that is away from the core board 1 in a thickness direction of the second sub-board 3, where the third insulation layer 8 is located between the second sub-board 3 and the third sub-board 7.

A fourth insulation layer 1a is taken, and the fourth insulation layer 1a and the fourth sub-board 9 are placed on a side that is of the first sub-board 2 and that is away from the core board 1 in a thickness direction of the first sub-board 2, where the fourth insulation layer 1a is located between the fourth sub-board 9 and the first sub-board 2.

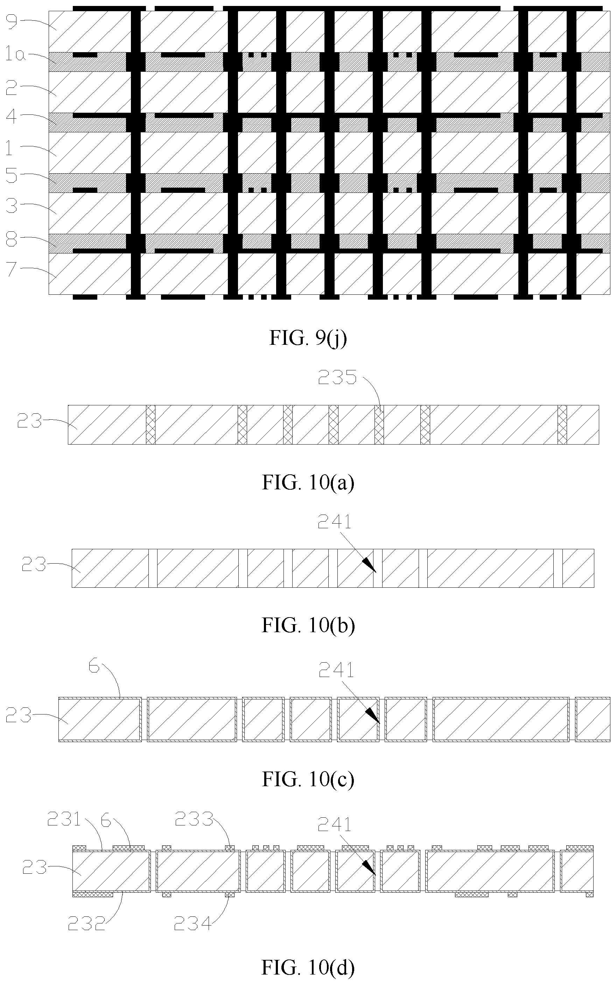

A multi-layer circuit board having five layers of stacked and combined substrates 1b shown in FIG. 9(j) is formed by performing the steps shown in FIG. 9(b) to FIG. 9(h).

A fourth aspect of embodiments of this application provides a method for processing a multi-layer circuit board, where the method for processing a multi-layer circuit board includes the following steps.

A first sub-board 2 is prepared, as shown in FIG. 6(a) to FIG. 6(d), or as shown in FIG. 10(a) to FIG. 10(d), a first substrate 23 is taken, and a first conductive pattern 21, a second conductive pattern 22, and a second via 241 are processed in the first substrate 23, where an extension direction of the second via 241 is parallel to a thickness direction of the first substrate 23, the first substrate 23 includes a first surface 231 and a second surface 232 that are disposed opposite to each other in the thickness direction of the first substrate 23, the first conductive pattern 21 is located on the first surface 231, and the second conductive pattern 22 is located on the second surface 232.

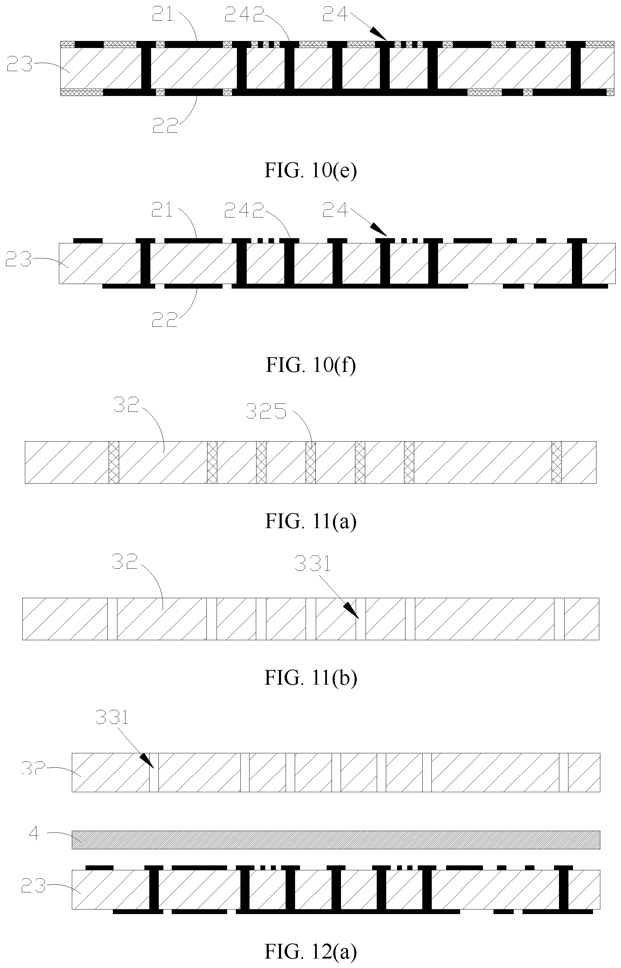

A second sub-board 3 is prepared, as shown in FIG. 7(c) and FIG. 7(d), or as shown in FIG. 11(a) and FIG. 11(b), a second substrate 32 is taken, and a third via 331 is processed in the second substrate 32, where an extension direction of the third via 331 is parallel to a thickness direction of the second substrate 32.

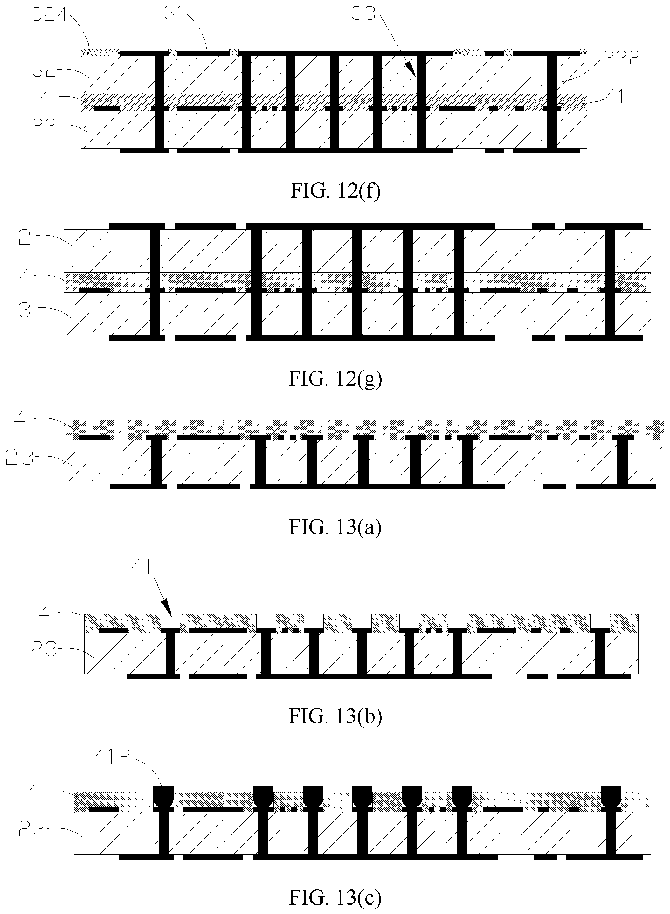

As shown in FIG. 8(a) or FIG. 12(a), a first insulation layer 4 is taken, and the second substrate 32 and the first insulation layer 4 are stacked on the first substrate 23 in the thickness direction of the first substrate 23, where the first insulation layer 4 is located between the second substrate 32 and the first substrate 23.

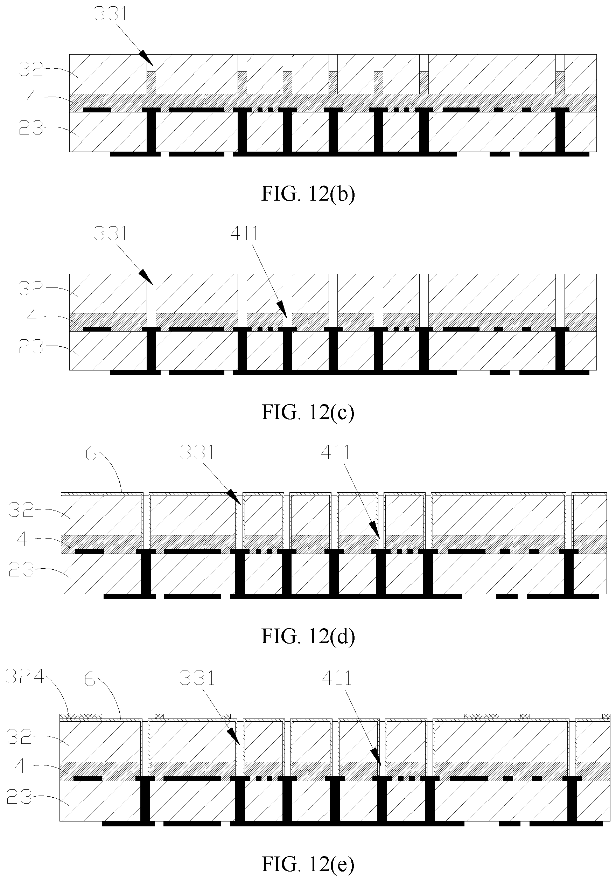

As shown in FIG. 8(b) or FIG. 12(b), the second substrate 32, the first insulation layer 4, and the first substrate 23 are fastened through press-fitting.

Before the step of stacking the second substrate 32 and the first insulation layer 4 on the first substrate 23, or after the step of fastening the second substrate 32, the first insulation layer 4, and the first substrate 23 through press-fitting, the method for processing a multi-layer circuit board includes the following steps.

As shown in FIG. 8(g) or FIG. 10(e) and FIG. 10(f), via-filling electroplating is performed on the first substrate 23, so that a second conductive medium 242 is filled into the second via 241 to form a second conductive channel 24.

Before the step of stacking the second substrate 32 and the first insulation layer 4 on the first substrate 23, or after the step of fastening the second substrate 32, the first insulation layer 4, and the first substrate 23 through press-fitting, the method for processing a multi-layer circuit board includes the following steps.

As shown in FIG. 7(a) and FIG. 7(b) or FIG. 12(e) and FIG. 12(f), a conductive pattern layer 31 is processed on the second substrate 32 in the thickness direction of the second substrate 32, where at least a portion of the conductive pattern layer 31 is located on a side that is of the second substrate 32 and that is away from the first substrate 23.

As shown in FIG. 8(g) or FIG. 12(e) and FIG. 12(f), the second substrate 32 includes a third surface 321 and a fourth surface 322 that are disposed opposite to each other in the thickness direction of the second substrate 32. The second substrate 32 is electroplated, to form a sixth conductive pattern on the fourth surface 322, and fill a third conductive medium 332 into the third via 331 to form a third conductive channel 33. The first insulation layer 4 includes a first conductive part 41, and the sixth conductive pattern is electrically connected through the third conductive channel 33, the first conductive part 41, and the second conductive channel 24.

In this embodiment, the second via 241 and the third via 331 are filled through via-filling electroplating, to reduce radial sizes required for the second via 241 and the third via 331. This helps enhance a routing density and a chip signal transmission capability of the multi-layer circuit board. In addition, this helps increase conductivity coefficients and thermal conductivity coefficients of the second conductive channel 24 and the third conductive channel 33, thereby helping improve electrical performance and thermal performance of the multi-layer circuit board, the chip system, and an electronic device. The via-filling electroplating is suitable for mass production, and a process yield is stable. This helps reduce processing costs of the chip system and the electronic device.

A sequence of the step of preparing the first sub-board 2 and the step of preparing the second sub-board 3 is not specially limited in embodiments. The steps may be performed simultaneously or sequentially.

When the difference between the area proportion of the first conductive pattern 21 on the first surface 231 and the area proportion of the second conductive pattern 22 on the second surface 232 is less than or equal to 50%, in other words, when the first conductive pattern 21 is similar to the second conductive pattern 22, the method for processing a multi-layer circuit board includes the following steps.

As shown in FIG. 5(a) to FIG. 5(d), a core board 1 is prepared, and as shown in FIG. 5(d), the core board 1 includes a first conductive channel 12 extending in a thickness direction of the core board 1.

As shown in FIG. 6(a) and FIG. 6(b), the first conductive pattern 21 and the second conductive pattern 22 are processed on the first substrate 23. The difference between the area proportion of the first conductive pattern 21 on the first surface 231 and the area proportion of the second conductive pattern 22 on the second surface 232 is less than or equal to 50%. The difference may be specifically 0%, 5%, 15%, 20%, 25%, 30%, 35%, 40%, 45%, 50%, or the like. For example, both the first conductive pattern 21 and the second conductive pattern 22 are ground layers or power supply layers. The ground layer is configured to implement grounding of the multi-layer circuit board, and the power supply layer is configured to support power supply distribution and management of an electrical component.

A second via 241 is processed in the first substrate 23 having the first conductive pattern 21 and the second conductive pattern 22.

The step of stacking the second substrate 32 and the first insulation layer 4 on the first substrate 23 includes the following steps.

As shown in FIG. 8(a), a second insulation layer 5 is taken, and the first sub-board 2, the first insulation layer 4, the core board 1, the second insulation layer 5, and the second sub-board 3 are stacked in a thickness direction of the multi-layer circuit board. The first insulation layer 4 is located between the first sub-board 2 and the core board 1, the second insulation layer 5 is located between the core board 1 and the second sub-board 3, the first conductive pattern 21 is located on a side of the first sub-board 2 and that is away from the core board 1, and the fourth conductive pattern 312 is located on a side that is of the second sub-board 3 and that is away from the core board 1.

The step of fastening the second substrate 32, the first insulation layer 4, and the first substrate 23 through press-fitting includes the following steps.

As shown in FIG. 8(b), the first sub-board 2, the first insulation layer 4, the core board 1, the second insulation layer 5, and the second sub-board 3 are fastened through press-fitting.

After the step of fastening the first sub-board 2, the first insulation layer 4, the core board 1, the second insulation layer 5, and the second sub-board 3 through press-fitting, the method for processing a multi-layer circuit board includes the following steps.

The first conductive pattern 21 is removed.

The first sub-board 2 is electroplated to form a fifth conductive pattern on the first surface 231, and a second conductive medium 242 is filled into the second via 241 to form the second conductive channel 24, where the fifth conductive pattern, the second conductive channel 24, and the second conductive pattern 22 form a signal transmission line structure.

The second insulation layer 5 includes a second conductive part 51. After the step of electroplating the first sub-board 2 to form the fifth conductive pattern and the second conductive channel 24, the fifth conductive pattern, the second conductive pattern 22, and the sixth conductive pattern are electrically connected through the second conductive channel 24, the first conductive part 41, the first conductive channel 12, the second conductive part 51, and the third conductive channel 33.

In this embodiment, the difference between the area proportion of the first conductive pattern 21 on the first surface 231 and the area proportion of the second conductive pattern 22 on the second surface 232 is less than or equal to 50%, so that the first conductive pattern 21 is similar to the second conductive pattern 22. Preferably, the first conductive pattern 21 and the second conductive pattern 22 are symmetrically designed relative to a plane perpendicular to the thickness direction of the multi-layer circuit board, so that mechanical features on two sides of the first sub-board 2 in the thickness direction are similar. This reduces a risk of warping and deformation of the first sub-board 2 in a subsequent processing process, and reduces difficulty in stacking the first sub-board 2 and the core board 1. In addition, this improves accuracy and reliability of an electrical connection between the first sub-board 2 and the core board 1, and an electrical connection between the first sub-board 2 and an element on the first sub-board 2 or the substrate 1b, thereby helping enhance working stability and reliability of the chip system and the electronic device. In a process of preparing the first sub-board 2, the first conductive pattern 21 is first removed, and then the fifth conductive pattern and the second conductive channel 24 are prepared. In this way, the fifth conductive pattern, the second conductive channel 24, and the second conductive pattern 22 form a signal transmission line structure, thereby reducing a signal transmission loss of the multi-layer circuit board.

A sequence of the step of preparing the core board 1, the step of preparing the first sub-board 2, and the step of preparing the second sub-board 3 is not specially limited in embodiments. The steps may be performed simultaneously or sequentially.

Specifically, in the process of preparing the core board 1, the first conductive channel 12 may be formed by machining a through hole and filling a conductive medium into the through hole, to reduce processing costs; or may be formed by laser etching a through hole and filling a conductive medium into the through hole, to improve processing precision.

In this embodiment, as shown in FIG. 5(a) to FIG. 5(d), the step of preparing the core board 1 includes the following steps.

As shown in FIG. 5(a), a core substrate 11 is taken, and laser induction is performed on the core substrate 11 to form a first phase change channel 111, where an extension direction of the first phase change channel 111 is parallel to a thickness direction of the substrate 1b.

As shown in FIG. 5(b), the core substrate 11 having a phase change channel is etched to form a first via 121.

A first conductive medium 122 is filled into the first via 121 to form the first conductive channel 12.

In this embodiment, the first via 121 is processed through laser induction and etching. This improves precision of a processing position and a processing size of the first via 121, and accuracy of positions at which the core board 1 is electrically connected to the first sub-board 2 and the second sub-board 3, thereby reducing difficulty in stacking and combining the core board 1, the first sub-board 2, and the second sub-board 3. A thickness of the core substrate 11 is 4 to 6 times a diameter of the first via 121, and the thickness of the core substrate 11 is between 100 µm and 200 µm, to increase a quantity and density of first vias 121, thereby improving bandwidth performance of the multi-layer circuit board.

In an embodiment, the step of filling the first conductive medium 122 into the first via 121 includes the following steps: The first conductive medium 122 is placed in the first via 121, where the first conductive medium 122 is solder or conductive paste; and the first via 121 is filled by melting the solder or the conductive paste, to simplify a method for processing the first conductive channel 12, thereby reducing processing costs of the first conductive channel 12.

In another embodiment, as shown in FIG. 5(c) and FIG. 5(d), the step of filling the first conductive medium 122 into the first via 121 includes the following steps.

A metal layer 6 is sputtered on an exposed surface of the core substrate 11 and a side wall of the first via 121.

The exposed surface of the core substrate 11 is covered with photoresist.

Via-filling electroplating is performed on the core substrate 11, to form the first conductive channel 12, where a conductor pattern is formed at two ends of the first conductive channel 12.

The photoresist and the metal layer 6 on the surface of the core substrate 11 are removed.

In this embodiment, the first conductive medium 122 is filled into the first via 121 through via-filling electroplating, to reduce a radial size required for the first via 121. This helps enhance a routing density and a chip signal transmission capability of the multi-layer circuit board. In addition, this helps increase a conductivity coefficient and a thermal conductivity coefficient of the first conductive channel 12, thereby helping improve electrical performance and thermal performance of the multi-layer circuit board, the chip system, and the electronic device. The via-filling electroplating is suitable for mass production, and a process yield is stable. In addition, the conductor pattern is formed at the two ends of the first conductive channel 12, so that an end part size of the first conductive channel 12 can be easily controlled, to improve processing precision of an end part of the first conductive channel 12, thereby increasing a processing yield of the core board 1. The end part size of the first conductive channel 12 includes but is not limited to a radial size, a thickness, and the like.

Specifically, before the step of processing the third via 331 in the second substrate 32, the method for processing a multi-layer circuit board includes the following steps.

A second substrate 32 is taken, and the second substrate 32 includes a third surface 321 and a fourth surface 322 that are disposed opposite to each other in a thickness direction of the second substrate 32. A third conductive pattern 311 is processed on the third surface 321, and a fourth conductive pattern 312 is processed on the fourth surface 322, to form the second sub-board 3. In an embodiment, the third conductive pattern 311 and the fourth conductive pattern 312 can form a signal transmission line structure by using a conductive medium. For example, the third conductive pattern 311 and the fourth conductive pattern 312 are asymmetrically designed, and one of the third conductive pattern 311 and the fourth conductive pattern 312 is a signal layer, and the other is a ground layer or a power supply layer. In another embodiment, a difference between an area proportion of the third conductive pattern 311 on the third surface 321 and an area proportion of the fourth conductive pattern 312 on the fourth surface 322 is less than or equal to 50%. The difference may be specifically 0%, 5%, 15%, 20%, 25%, 30%, 35%, 40%, 45%, 50%, or the like. For example, both the third conductive pattern 311 and the fourth conductive pattern 312 are signal layers, in other words, the third conductive pattern 311 is similar to the fourth conductive pattern 312. Preferably, the third conductive pattern 311 and the fourth conductive pattern 312 are symmetrically designed relative to a plane perpendicular to the thickness direction of the multi-layer circuit board.

When the difference between the area proportion of the third conductive pattern 311 on the third surface 321 and the area proportion of the fourth conductive pattern 312 on the fourth surface 322 is less than or equal to 50%, after the step of fastening the first sub-board 2, the first insulation layer 4, the core board 1, the second insulation layer 5, and the second sub-board 3 through press-fitting, the fourth conductive pattern 312 is located on a side that is of the second substrate 32 and that is away from the first substrate 23, and the method for processing a multi-layer circuit board includes the following steps.

The fourth conductive pattern 312 is removed.

In this embodiment, the third conductive pattern 311 is similar to the fourth conductive pattern 312, so that mechanical features on two sides of the second sub-board 3 in the thickness direction are similar. This reduces a risk of warping and deformation of the second sub-board 3 in a subsequent processing process, reduces difficulty in stacking the second sub-board 3 and the core board 1, and improves accuracy and reliability of an electrical connection between the second sub-board 3 and the core board 1, and an electrical connection between the second sub-board 3 and an element on the second sub-board 3 or the substrate 1b, thereby increasing a production yield of the multi-layer circuit board, the chip system, and the electronic device. In a process of preparing the second sub-board 3, the fourth conductive pattern 312 is first removed, and then the sixth conductive pattern and the third conductive channel 33 are prepared. In this way, the sixth conductive pattern, the third conductive channel 33, and the third conductive pattern 311 form a signal transmission line structure, thereby reducing a signal transmission loss of the multi-layer circuit board.

Specifically, in an embodiment, the step of preparing the first sub-board 2 includes the following steps.

The first substrate 23 is taken, and the first substrate 23 includes the first surface 231 and the second surface 232 that are disposed opposite to each other in the thickness direction of the first substrate 23.

The first conductive pattern 21 is printed on the first surface 231, and the second conductive pattern 22 is printed on the second surface 232.

In this embodiment, the first conductive pattern 21 and the second conductive pattern 22 are processed through printing. This simplifies a processing manner of the first sub-board 2, thereby helping reduce processing costs of the first sub-board 2.

In another embodiment, as shown in FIG. 6(a) and FIG. 6(b), the step of preparing the first sub-board 2 includes the following steps.

The first substrate 23 is taken, and a metal layer 6 is sputtered on the first surface 231 and the second surface 232.

The first surface 231 is covered with first photoresist 233, and the second surface 232 is covered with second photoresist 234.

Photolithography is performed on the first surface 231 to form a first pattern, and photolithography is performed on the second surface 232 to form a second pattern.

The first pattern and the second pattern are electroplated to form the first conductive pattern 21 and the second conductive pattern 22.

The first photoresist 233, the second photoresist 234, and the metal layer 6 are removed.

In this embodiment, the first conductive pattern 21 and the second conductive pattern 22 are processed through photolithography and electroplating. This improves accuracy of parameters such as shapes, positions, and sizes of the first conductive pattern 21 and the second conductive pattern 22, thereby increasing a processing yield of the first sub-board 2.

More specifically, the step of preparing the first sub-board 2 further includes the following step: The second via 241 is processed in the first sub-board 2. The step of processing the second via 241 in the first sub-board 2 may be performed before or after the step of processing the first conductive pattern 21 and the second conductive pattern 22.

In an embodiment, the first sub-board 2 is drilled through machining to form the second via 241, thereby simplifying a processing manner of the first sub-board 2, and reducing processing costs.

In another embodiment, as shown in FIG. 6(c) and FIG. 6(d), the step of processing the second via 241 in the first sub-board 2 includes the following steps.

Laser induction is performed on the first substrate 23 to form a second phase change channel 235, where an extension direction of the second phase change channel 235 is parallel to a thickness direction of the substrate 1b.

The first substrate 23 having two phase change channels is etched to form the second via 241.

In this embodiment, the second via 241 is processed through laser induction and etching. This improves precision of a processing position and a processing size of the second via 241, thereby enhancing accuracy of a position at which the first sub-board 2 is electrically connected to the core board 1, and further reducing difficulty in stacking and combining the first sub-board 2 and the core board 1. A thickness of the first substrate 23 is 4 to 6 times a diameter of the second via 241, and the thickness of the first substrate 23 is between 100 µm and 200 µm, to increase a quantity and density of the second vias 241, thereby improving bandwidth performance of the multi-layer circuit board.

More specifically, the step of electroplating the first sub-board 2 includes the following steps.

As shown in FIG. 8(e), a metal layer 6 is sputtered on the first surface 231 and a side wall of the second via 241.

As shown in FIG. 8(f), the first surface 231 is covered with fifth photoresist 236.

Photolithography is performed on the first surface 231 to form a fifth pattern.

As shown in FIG. 8(g), the fifth pattern and the second via 241 are electroplated, so that the second conductive medium 242 covers the fifth pattern and is filled into the second via 241, to form the fifth conductive pattern and the second conductive channel 24.

As shown in FIG. 8(h), the fifth photoresist 236 and the metal layer 6 on the surface of the first substrate 23 are removed.

In this embodiment, the second conductive medium 242 is filled into the second via 241 through via-filling electroplating, to reduce a radial size required for the second via 241. This helps enhance a routing density and a chip signal transmission capability of the multi-layer circuit board. In addition, this helps increase a conductivity coefficient and a thermal conductivity coefficient of the second conductive channel 24, thereby helping improve electrical performance and thermal performance of the multi-layer circuit board and the chip system. The via-filling electroplating is suitable for mass production, and a process yield is stable. The fifth conductive pattern and the second conductive channel 24 are electroplated and processed simultaneously, thereby simplifying processing operations and a processing periodicity of the first sub-board 2.

Specifically, in an embodiment, the step of preparing the second sub-board 3 includes the following steps.

The second substrate 32 is taken, and the second substrate 32 includes the third surface 321 and the fourth surface 322 that are disposed opposite to each other in the thickness direction of the second substrate 32.

The third conductive pattern 311 is printed on the third surface 321, and the fourth conductive pattern 312 is printed on the fourth surface 322.

In this embodiment, the third conductive pattern 311 and the fourth conductive pattern 312 are processed through printing. This simplifies a processing manner of the second sub-board 3, thereby helping reduce processing costs of the second sub-board 3.

In another embodiment, as shown in FIG. 7(a) and FIG. 7(b), the step of preparing the second sub-board 3 includes the following steps.

The second substrate 32 is taken, and a metal layer 6 is sputtered on the third surface 321 and the fourth surface 322.

The third surface 321 is covered with third photoresist 323, and the fourth surface 322 is covered with fourth photoresist 324.

Photolithography is performed on the third surface 321 to form a third pattern, and photolithography is performed on the fourth surface 322 to form a fourth pattern.

The third pattern and the fourth pattern are electroplated to form the third conductive pattern 311 and the fourth conductive pattern 312.

The third photoresist 323, the fourth photoresist 324, and the metal layer 6 are removed.

In this embodiment, the third conductive pattern 311 and the fourth conductive pattern 312 are processed through photolithography and electroplating. This improves accuracy of parameters such as shapes, positions, and sizes of the third conductive pattern 311 and the fourth conductive pattern 312, thereby increasing a processing yield of the second sub-board 3.

More specifically, the step of preparing the second sub-board 3 further includes the following step: The third via 331 is processed in the second sub-board 3. The step of processing the third via 331 in the second sub-board 3 may be performed before or after the step of processing the third conductive pattern 311 and the fourth conductive pattern 312.

In an embodiment, the second sub-board 3 is drilled through machining to form the third via 331, thereby simplifying a processing manner of the second sub-board 3, and reducing processing costs.

In another embodiment, as shown in FIG. 7(c) and FIG. 7(d), the step of preparing the second sub-board 3 includes the following steps.

Laser induction is performed on the second substrate 32 to form a third phase change channel 325, where an extension direction of the third phase change channel 325 is parallel to the thickness direction of the substrate 1b.

The second substrate 32 having three phase change channels is etched to form the third via 331.

In this embodiment, the third via 331 is processed through laser induction and etching. This improves precision of a processing position and a processing size of the third via 331, and accuracy of a position at which the second sub-board 3 is electrically connected to the core board 1, thereby reducing difficulty in stacking and combining the second sub-board 3 and the core board 1. A thickness of the second substrate 32 is 4 to 6 times a diameter of the third via 331, and the thickness of the second substrate 32 is between 100 µm and 200 µm, to increase a quantity and density of third vias 331, thereby improving bandwidth performance of the multi-layer circuit board.

More specifically, the step of electroplating the second sub-board 3 includes the following steps.

As shown in FIG. 8(e), the metal layer 6 is sputtered on the fourth surface 322 and a side wall of the third via 331.

As shown in FIG. 8(f), the fourth surface 322 is covered with sixth photoresist 326.

Photolithography is performed on the fourth surface 322 to form a sixth pattern.

As shown in FIG. 8(g), the sixth pattern and the third via 331 are electroplated, so that the third conductive medium 332 covers the sixth pattern and is filled into the third via 331, to form the sixth conductive pattern 1c and the third conductive channel 33.

As shown in FIG. 8(h), the sixth photoresist 326 and the metal layer 6 are removed.

In this embodiment, the third conductive medium 332 is filled into the third via 331 through via-filling electroplating. This reduces a radial size required for the third via 331, and helps enhance a routing density and a chip signal transmission capability of the multi-layer circuit board. In addition, this helps increase a conductivity coefficient and a thermal conductivity coefficient of the third conductive channel 33, thereby helping improve electrical performance and thermal performance of the multi-layer circuit board and the chip system. The via-filling electroplating is suitable for mass production, and a process yield is stable. The sixth conductive pattern 1c and the third conductive channel 33 are electroplated and processed simultaneously, thereby simplifying processing operations and a processing periodicity of the first sub-board 2.

When the multi-layer circuit board further includes a third sub-board 7 that is disposed through stacking, the method for processing a multi-layer circuit board further includes the following steps.

The third sub-board 7 shown in FIG. 8(i) is prepared according to the steps of preparing the first sub-board 2 and the second sub-board 3. The third sub-board 7 includes a third substrate, where the third substrate includes a fourth via extending in a thickness direction of the third substrate. The third sub-board 7 includes a fifth surface and a sixth surface that are disposed opposite to each other in a thickness direction of the third sub-board 7. A seventh conductive pattern 71 is disposed on the fifth surface, and an eighth conductive pattern 72 is disposed on the sixth surface. A difference between an area proportion of the seventh conductive pattern 71 on the fifth surface and an area proportion of the eighth conductive pattern 72 on the sixth surface is less than or equal to 50%. The difference may be specifically 0%, 5%, 15%, 20%, 25%, 30%, 35%, 40%, 45%, 50%, or the like. For example, both the seventh conductive pattern 71 and the eighth conductive pattern 72 are ground layers or power supply layers, in other words, the seventh conductive pattern 71 is similar to the eighth conductive pattern 72. Preferably, the seventh conductive pattern 71 and the eighth conductive pattern 72 are symmetrically designed relative to a plane perpendicular to the thickness direction of the multi-layer circuit board.

A third insulation layer 8 is taken, and the third insulation layer 8 and the third sub-board 7 are placed on a side that is of the second sub-board 3 and that is away from the core board 1 in a thickness direction of the second sub-board 3, where the third insulation layer 8 is located between the second sub-board 3 and the third sub-board 7.

The second sub-board 3 and the third sub-board 7 are fastened through press-fitting.

The eighth conductive pattern 72 is removed.

The third sub-board 7 is electroplated, to form an eleventh conductive pattern on the sixth surface, and fill a sixth conductive medium into the fourth via to form the fourth conductive channel 1b1. The eleventh conductive pattern, the fourth conductive channel 1b1, and the seventh conductive pattern 71 form a signal transmission line structure. The third sub-board 7 is electrically connected to the second sub-board 3 through the fourth conductive channel 1b1 and the third conductive part on the third insulation layer 8.

In addition/alternatively, when the multi-layer circuit board further includes a fourth sub-board 9 that is disposed through stacking, the method for processing a multi-layer circuit board further includes the following steps.

The fourth sub-board 9 shown in FIG. 8(i) is prepared according to the steps of preparing the first sub-board 2 and the second sub-board 3. The fourth sub-board 9 includes a plurality of fourth substrates, where the fourth substrate includes a fifth via extending in a thickness direction of the fourth substrate. The fourth substrate includes a seventh surface and an eighth surface that are disposed opposite to each other in the thickness direction of the fourth substrate. A ninth conductive pattern 91 is disposed on the seventh surface, and a tenth conductive pattern 92 is disposed on the eighth surface. A difference between an area proportion of the ninth conductive pattern 91 on the seventh surface and an area proportion of the tenth conductive pattern 92 on the eighth surface is less than or equal to 50%. The difference may be specifically 0%, 5%, 15%, 20%, 25%, 30%, 35%, 40%, 45%, 50%, or the like. For example, both the ninth conductive pattern 91 and the tenth conductive pattern 92 are signal layers, in other words, the ninth conductive pattern 91 is similar to the tenth conductive pattern 92. Preferably, the ninth conductive pattern 91 and the tenth conductive pattern 92 are symmetrically designed relative to a plane perpendicular to the thickness direction of the multi-layer circuit board.

A fourth insulation layer 1a is taken, and the fourth insulation layer 1a and the fourth sub-board 9 are placed on a side that is of the first sub-board 2 and that is away from the core board 1 in a thickness direction of the first sub-board 2, where the fourth insulation layer 1a is located between the fourth sub-board 9 and the first sub-board 2.

The fourth sub-board 9 and the first sub-board 2 are fastened through press-fitting.

The ninth conductive pattern 91 is removed.

The fourth sub-board 9 is electroplated, to form an eleventh conductive pattern on the seventh surface, and fill a seventh conductive medium into the fifth via to form a fifth conductive channel 1b1. The fourth sub-board 9 is electrically connected to the first sub-board 2 through the fifth conductive channel 1b1, the fourth conductive part on the fourth insulation layer 1a, and the second conductive channel 24.

In this embodiment, the multi-layer circuit board further includes the third sub-board 7 and the fourth sub-board 9, and a quantity of stacked substrates on the multi-layer circuit board is increased, to meet a signal transmission requirement of a chip system with higher performance. The difference between the area proportion of the seventh conductive pattern 71 and the area proportion of the eighth conductive pattern 72 and the difference between the area proportion of the ninth conductive pattern 91 and the area proportion of the tenth conductive pattern 92 are less than or equal to 50%. In this way, the third sub-board and the fourth sub-board 9 have similar mechanical features on two sides, thereby reducing a risk of deformation of the third sub-board and the fourth sub-board 9.

In addition, the multi-layer circuit board may further include a fifth sub-board, a sixth sub-board, a seventh sub-board, and the like. A quantity of stacked substrates 1b on the multi-layer circuit board is not specially limited in this application.

When the first conductive pattern 21, the second conductive pattern 22, and the second conductive channel 24 form a signal transmission line structure, for example, when the first conductive pattern 21 is a signal layer and the second conductive pattern 22 is a ground layer or a power supply layer, the first conductive pattern 21 and the second conductive pattern 22 are asymmetrically designed. In this case, the step of performing via-filling electroplating on the first substrate 23 to form the second conductive channel 24 and the step of processing the first conductive pattern 21 and the second conductive pattern 22 on the first substrate 23 are simultaneously performed.

The step of processing the first conductive pattern 21, the second conductive pattern 22, and the second conductive channel 24 on the first substrate 23 includes the following steps.

The second via 241 is processed in the first substrate 23.

A metal layer 6 is sputtered on the first surface 231 and the second surface 232 of the first substrate 23 having the second via 241.

The first surface 231 is covered with first photoresist 233, and the second surface 232 is covered with second photoresist 234.

Photolithography is performed on the first surface 231 to form a first pattern, and photolithography is performed on the second surface to form a second pattern.

The first pattern, the second pattern, and the second via 241 are electroplated to form the first conductive pattern 21, the second conductive pattern 22, and the second conductive channel 24.

In this embodiment of this application, the first conductive pattern 21, the second conductive channel 24, and the second conductive pattern 22 can form a signal transmission line structure, so that the foregoing core board 1 can be omitted. This helps reduce an overall thickness of the multi-layer circuit board, helps reduce an overall size of the chip system, and improve space utilization of a device body, thereby helping reduce an overall size of the electronic device and reduce costs of the electronic device.

When the multi-layer circuit board further includes a third sub-board 7 that is disposed through stacking, the method for processing a multi-layer circuit board further includes the following steps.

A third sub-board 7 is prepared, where the third sub-board 7 includes a fourth via extending in a thickness direction of the third sub-board 7.

After the step of fastening the second substrate 32, the first insulation layer 4, and the first substrate 23 through press-fitting, the method for processing a multi-layer circuit board includes the following steps.

A third insulation layer 8 is taken, and the third insulation layer 8 and the third sub-board 7 are placed on a side that is of the second substrate 32 and that is away from the first substrate 23 in a thickness direction of the second substrate 32, where the third insulation layer 8 is located between the third sub-board 7 and the second substrate 32.

The third sub-board 7 and the second substrate 32 are fastened through press-fitting.

The third sub-board 7 is electroplated, to form an eleventh conductive pattern on a surface on a side that is of the third sub-board 7 and that is away from the second substrate 32, and fill a fourth conductive medium into the fourth via to form a fourth conductive channel. The third insulation layer 8 includes a third conductive part, and the eleventh conductive pattern is electrically connected to the sixth conductive pattern through the fourth conductive channel and the third conductive part.

In addition/alternatively, when the multi-layer circuit board further includes a fourth sub-board 9 that is disposed through stacking, the method for processing a multi-layer circuit board further includes the following steps.

The fourth sub-board 9 is prepared, where the fourth sub-board 9 includes a fifth via extending in a thickness direction of the fourth sub-board 9.

After the step of fastening the second substrate 32, the first insulation layer 4, and the first substrate 23 through press-fitting, the method for processing a multi-layer circuit board includes the following steps.

A fourth insulation layer 1a is taken, and the fourth sub-board 9 and the fourth insulation layer 1a are placed on a side that is of the first substrate 23 and that is away from the second substrate 32 in a thickness direction of the first substrate 23, where the fourth insulation layer 1a is located between the first substrate 23 and the fourth sub-board 9.

The first substrate 23 and the fourth sub-board 9 are fastened through press-fitting.

The fourth sub-board 9 is electroplated, to form a twelfth conductive pattern on a surface on a side that is of the fourth sub-board 9 and that is away from the first substrate 23, and fill a fifth conductive medium into the fifth via to form a fifth conductive channel. The fourth insulation layer 1a includes a fourth conductive part, and the twelfth conductive pattern is electrically connected to the first conductive pattern 21 through the fifth conductive channel and the fourth conductive part.

In this embodiment, the multi-layer circuit board further includes the third sub-board 7 and the fourth sub-board 9, and a quantity of stacked substrates 1b on the multi-layer circuit board is increased, to improve bandwidth performance of the multi-layer circuit board, so that the multi-layer circuit board can be used in a chip system having a higher bandwidth requirement. This improves an application scenario of the multi-layer circuit board and further helps enhance working performance of the chip system.

In addition, the multi-layer circuit board may further include a fifth sub-board, a sixth sub-board, a seventh sub-board, and the like. A quantity of stacked substrates 1b on the multi-layer circuit board is not specially limited in this application.

In any one of the foregoing embodiments, the first conductive part 41 on the first insulation layer 4 and the second conductive part 51 on the second insulation layer 5 are processed by using the foregoing via-filling electroplating process. To be specific, as shown in FIG. 8(a) to FIG. 8(g), the step of stacking the first sub-board 2, the first insulation layer 4, the core board 1, the second insulation layer 5, and the second sub-board 3 includes the following steps.

As shown in FIG. 8(a), the first insulation layer 4 and the second insulation layer 5 are respectively placed on two sides of the core board 1 in the thickness direction of the core board 1, the first sub-board 2 is placed on a side that is of the first insulation layer 4 and that is away from the core board 1 in the thickness direction of the core board 1, and the second sub-board 3 is placed on a side that is of the second insulation layer 5 and that is away from the core board 1.

After the step of fastening the first sub-board 2, the first insulation layer 4, the core board 1, the second insulation layer 5, and the second sub-board 3 through press-fitting, the method for processing a multi-layer circuit board includes the following steps.

As shown in FIG. 8(d), a first through hole 411 is processed in the first insulation layer 4, and a second through hole 511 is processed in the second insulation layer 5. The first through hole 411 penetrates the first insulation layer 4 in a thickness direction of the first insulation layer 4, and the second through hole 511 penetrates the second insulation layer 5 in a thickness direction of the second insulation layer 5.

A metal layer 6 is sputtered on a side wall of the first through hole 411 and a side wall of the second through hole 511.

Via-filling electroplating is performed on the first through hole 411 to form the first conductive part 41, and via-filling electroplating is performed on the second through hole 511 to form the second conductive part 51.

In this embodiment, the first conductive part 41 and the second conductive part 51 are processed through via-filling electroplating, to reduce radial sizes required for the first conductive part 41 and the second conductive part 51. This helps enhance a routing density and a chip signal transmission capability of the multi-layer circuit board. In addition, this helps increase conductivity coefficients and thermal conductivity coefficients of the first conductive part and the second conductive part, thereby helping improve electrical performance and thermal performance of the multi-layer circuit board, the chip system, and the electronic device. The via-filling electroplating is suitable for mass production, and a process yield is stable.

In another embodiment, the first conductive part 41 on the first insulation layer 4 and the second conductive part 51 on the second insulation layer 5 are formed by filling the solar or conductive paste. To be specific, as shown in FIG. 9(a) to FIG. 9(d), the step of stacking the first sub-board 2, the first insulation layer 4, the core board 1, the second insulation layer 5, and the second sub-board 3 includes the following steps.

As shown in FIG. 9(a), the first insulation layer 4 and the second insulation layer 5 are respectively placed on two sides of the core board 1 in the thickness direction of the core board 1.

As shown in FIG. 9(b), a first through hole 411 is processed in the first insulation layer 4, and a second through hole 511 is processed in the second insulation layer 5. The first through hole 411 penetrates the first insulation layer 4 in a thickness direction of the first insulation layer 4, and the second through hole 511 penetrates the second insulation layer 5 in a thickness direction of the second insulation layer 5.

As shown in FIG. 9(c), the fourth conductive medium 412 is placed in the first through hole 411, and the fifth conductive medium 512 is placed in the second through hole 511. The fourth conductive medium 412 is solder or conductive paste, and the fifth conductive medium 512 is solder or conductive paste.

As shown in FIG. 9(d), the first sub-board 2 is placed on a side that is of the first insulation layer 4 and that is away from the core board 1 in the thickness direction of the core board 1, and the second sub-board 3 is placed on a side that is of the second insulation layer 5 and that is away from the core board 1.

In this embodiment, the first through hole 411 and the second through hole 511 are filled by melting the solder or the conductive paste, to simplify a method for processing the first through hole 411 and the second through hole 511, thereby reducing processing costs of the first insulation layer 4 and the second insulation layer 5, and further reducing processing costs of the multi-layer circuit board, and the chip system.

The substrate 1b like the core substrate 11, the first substrate 23, the second substrate 32, the third substrate, and the fourth substrate in any one of the foregoing embodiments is formed by processing a plate-like substrate, to be specific, the plate-like substrate is cut, so that a length, width, and thickness of the cut plate-like substrate all meet use requirements of the multi-layer circuit board.

In conclusion, in an embodiment, a method for processing a multi-layer circuit board includes the following steps.

As shown in FIG. 5(a), a core substrate 11 is taken, and laser induction is performed on the core substrate 11 to form a first phase change channel 111, where an extension direction of the first phase change channel 111 is parallel to a thickness direction of the substrate 1b.

As shown in FIG. 5(b), the core substrate 11 having a phase change channel is etched to form a first via 121.

As shown in FIG. 5(c), a metal layer 6 is sputtered on the exposed surface of the core substrate 11 and a side wall of the first via 121.

The exposed surface of the core substrate 11 is covered with photoresist.

As shown in FIG. 5(d), via-filling electroplating is performed on the core substrate 11, to form a first conductive channel 12, where a conductor pattern is formed at two ends of the first conductive channel 12.

The photoresist and the metal layer 6 on the surface of the core substrate 11 are removed.

As shown in FIG. 6(a), a first substrate 23 is taken, and a metal layer 6 is covered on the first surface 231 and the second surface 232.

The first surface 231 is covered with first photoresist 233, and the second surface 232 is covered with second photoresist 234.

Photolithography is performed on the first surface 231 to form a first pattern, and photolithography is performed on the second surface to form a second pattern.

The first pattern and the second pattern are electroplated to form a first conductive pattern 21 and a second conductive pattern 22, where a difference between an area proportion of the first conductive pattern 21 on the first surface 231 and an area proportion of the second conductive pattern 22 on the second surface 232 is less than or equal to 50%.

The first photoresist 233, the second photoresist 234, and the metal layer 6 are removed.

As shown in FIG. 6(c), laser induction is performed on the first substrate 23 to form a second phase change channel 235, where an extension direction of the second phase change channel 235 is parallel to the thickness direction of the substrate 1b.

As shown in FIG. 6(d), the first substrate 23 having two phase change channels is etched to form a second via 241.

As shown in FIG. 7(a), a second substrate 32 is taken, and a metal layer 6 is sputtered on a third surface 321 and a fourth surface 322.

The third surface 321 is covered with third photoresist 323, and the fourth surface 322 is covered with fourth photoresist 324.

Photolithography is performed on the third surface 321 to form a third pattern, and photolithography is performed on the second surface 232 to form a fourth pattern.

The third pattern and the fourth pattern are electroplated to form a third conductive pattern 311 and a fourth conductive pattern 312, where both the third conductive pattern 311 and the fourth conductive pattern 312 are signal layers, in other words, the third conductive pattern 311 is similar to the fourth conductive pattern 312, and a difference between an area proportion of the third conductive pattern 311 on the third surface 321 and an area proportion of the fourth conductive pattern 312 on the fourth surface 322 is less than or equal to 50%.

The third photoresist 323, the fourth photoresist 324, and the metal layer 6 are removed.

As shown in FIG. 7(c), laser induction is performed on the second substrate 32 to form a third phase change channel 325, where an extension direction of the third phase change channel 325 is parallel to the thickness direction of the substrate 1b.

As shown in FIG. 7(d), the second substrate 32 having three phase change channels is etched to form a third via 331.

As shown in FIG. 8(a), a first insulation layer 4 and a second insulation layer 5 are taken, and the first sub-board 2, the first insulation layer 4, the core board 1, the second insulation layer 5, and the second sub-board 3 are stacked in a thickness direction of the multi-layer circuit board. The first insulation layer 4 is located between the first sub-board 2 and the core board 1, the second insulation layer 5 is located between the core board 1 and the second sub-board 3, the first conductive pattern 21 is located on a side that is of the first sub-board 2 and that is away from the core board 1, and the fourth conductive pattern 312 is located on a side that is of the second sub-board 3 and that is away from the core board 1.

As shown in FIG. 8(b), the first sub-board 2, the first insulation layer 4, the core board 1, the second insulation layer 5, and the second sub-board 3 are fastened through press-fitting.

As shown in FIG. 8(c), the first conductive pattern 21 and the fourth conductive pattern 312 are removed.

As shown in FIG. 8(d), a first through hole 411 is processed in the first insulation layer 4, and a second through hole 511 is processed in the second insulation layer 5. The first through hole 411 penetrates the first insulation layer 4 in a thickness direction of the first insulation layer 4, and the second through hole 511 penetrates the second insulation layer 5 in a thickness direction of the second insulation layer 5.

As shown in FIG. 8(e), a metal layer 6 is sputtered on the first surface 231, the second via 241, the first through hole 411, the fourth surface 322, the third via 331, and a side wall of the second through hole 511.

As shown in FIG. 8(f), the first surface 231 is covered with fifth photoresist 236, and the fourth surface 322 is covered with sixth photoresist 326.

Photolithography is performed on the first surface 231 to form a fifth pattern, and photolithography is performed on the fourth surface 322 to form a sixth pattern.

As shown in FIG. 8(g), the first sub-board 2 and the first insulation layer 4 are electroplated to form a fifth conductive pattern, a second conductive channel 24, and a first conductive part 41, where the fifth conductive pattern, the second conductive channel 24, and the second conductive pattern 22 form a signal transmission line structure; and the second sub-board 3 and the second insulation layer 5 are electroplated to form a sixth conductive pattern, a third conductive channel 33, and a second conductive part 51, where the sixth conductive pattern, the third conductive channel 33, and the third conductive pattern 311 form a signal transmission line structure.

As shown in FIG. 8(h), the fifth photoresist 236, the sixth photoresist 326, and the metal layer 6 are removed.

A third sub-board 7 and a fourth sub-board 9 are prepared according to steps of preparing the first sub-board 2 and the second sub-board 3. The third sub-board 7 includes a fourth via extending in a thickness direction of the third sub-board 7, and the third sub-board 7 includes a seventh conductive pattern 71 and an eighth conductive pattern 72 that are disposed opposite to each other in the thickness direction of the third sub-board 7. A difference between an area proportion of the seventh conductive pattern 71 on the fifth surface and an area proportion of the eighth conductive pattern 72 on the sixth surface is less than or equal to 50%. The fourth sub-board 9 includes a fifth via extending in a thickness direction of the fourth sub-board 9, and the fourth sub-board 9 includes a ninth conductive pattern 91 and a tenth conductive pattern 92 that are disposed opposite to each other in the thickness direction of the fourth sub-board 9. A difference between an area proportion of the ninth conductive pattern 91 on the seventh surface and an area proportion of the tenth conductive pattern 92 on the eighth surface is less than or equal to 50%.

As shown in FIG. 8(i), a third insulation layer 8 is taken, and the third insulation layer 8 and the third sub-board 7 are placed on a side that is of the second sub-board 3 and that is away from the core board 1 in a thickness direction of the second sub-board 3, where the third insulation layer 8 is located between the second sub-board 3 and the third sub-board 7.

A fourth insulation layer 1a is taken, and the fourth insulation layer 1a and the fourth sub-board 9 are placed on a side that is of the first sub-board 2 and that is away from the core board 1 in a thickness direction of the first sub-board 2, where the fourth insulation layer 1a is located between the fourth sub-board 9 and the first sub-board 2.

The third sub-board 7, the third insulation layer 8, and the second sub-board 3 are fastened through press-fitting, and the fourth sub-board 9, the fourth insulation layer 1a, and the first sub-board 2 are fastened through press-fitting.

A multi-layer circuit board having five layers of stacked and combined substrates 1b shown in FIG. 8(j) is formed by performing the steps shown in FIG. 8(c) to FIG. 8(h).

In conclusion, in another embodiment, a method for processing a multi-layer circuit board includes the following steps.

As shown in FIG. 5(a), a core substrate 11 is taken, and laser induction is performed on the core substrate 11 to form a first phase change channel 111, where an extension direction of the first phase change channel 111 is parallel to a thickness direction of the substrate 1b.

As shown in FIG. 5(b), the core substrate 11 having a phase change channel is etched to form a first via 121.

As shown in FIG. 5(c), a metal layer 6 is sputtered on the exposed surface of the core substrate 11 and a side wall of the first via 121;

The exposed surface of the core substrate 11 is covered with photoresist.

As shown in FIG. 5(d), via-filling electroplating is performed on the core substrate 11 to form a first conductive channel 12, where a conductor pattern is formed at two ends of the first conductive channel 12.

The photoresist and the metal layer 6 on the surface of the core substrate 11 are removed.

As shown in FIG. 6(a), a first substrate 23 is taken, and a metal layer 6 is sputtered on the first surface 231 and the second surface 232.

The first surface 231 is covered with first photoresist 233, and the second surface 232 is covered with second photoresist 234.

Photolithography is performed on the first surface 231 to form a first pattern, and photolithography is performed on the second surface to form a second pattern.

The first pattern and the second pattern are electroplated to form a first conductive pattern 21 and a second conductive pattern 22, where a difference between an area proportion of the first conductive pattern 21 on the first surface 231 and an area proportion of the second conductive pattern 22 on the second surface 232 is less than or equal to 50%.

The first photoresist 233, the second photoresist 234, and the metal layer 6 are removed.

As shown in FIG. 6(c), laser induction is performed on the first substrate 23 to form a second phase change channel 235, where an extension direction of the second phase change channel 235 is parallel to the thickness direction of the substrate 1b.

As shown in FIG. 6(d), the first substrate 23 having two phase change channels is etched to form a second via 241.

As shown in FIG. 7(a), a second substrate 32 is taken, and a metal layer 6 is sputtered on a third surface 321 and a fourth surface 322.

The third surface 321 is covered with third photoresist 323, and the fourth surface 322 is covered with fourth photoresist 324.

Photolithography is performed on the third surface 321 to form a third pattern, and photolithography is performed on the second surface 232 to form a fourth pattern.

The third pattern and the fourth pattern are electroplated to form a third conductive pattern 311 and a fourth conductive pattern 312, where a difference between an area proportion of the third conductive pattern 311 on the third surface 321 and an area proportion of the fourth conductive pattern 312 on the fourth surface 322 is less than or equal to 50%.

The third photoresist 323, the fourth photoresist 324, and the metal layer 6 are removed.

As shown in FIG. 7(c), laser induction is performed on the second substrate 32 to form a third phase change channel 325, where an extension direction of the third phase change channel 325 is parallel to the thickness direction of the substrate 1b.

As shown in FIG. 7(d), the second substrate 32 having three phase change channels is etched to form a third via 331.

As shown in FIG. 9(a), a first insulation layer 4 and a second insulation layer 5 are taken, and the first insulation layer 4, the core board 1, and the second insulation layer 5 are stacked in a thickness direction of the multi-layer circuit board.

As shown in FIG. 9(b), a first through hole 411 is processed in the first insulation layer 4, and a second through hole 511 is processed in the second insulation layer 5.

As shown in FIG. 9(c), solder or conductive paste is placed in the first through hole 411 and the second through hole 511.

As shown in FIG. 9(d), the first sub-board 2 is placed on a side that is of the first insulation layer 4 and that is away from the core board 1, the second sub-board 3 is placed on a side that is of the second insulation layer 5 and that is away from the core board 1, and the first sub-board 2, the first insulation layer 4, the core board 1, the second insulation layer 5, and the second sub-board 3 are fastened through press-fitting.

As shown in FIG. 9(e), the first conductive pattern 21 and the fourth conductive pattern 312 are removed.

As shown in FIG. 9(f), a metal layer 6 is sputtered on the first surface 231, the second via 241, the fourth surface 322, and a side wall of the third via 331.

As shown in FIG. 9(g), the first surface 231 is covered with fifth photoresist 236, and the fourth surface 322 is covered with sixth photoresist 326.

Photolithography is performed on the first surface 231 to form a fifth pattern, and photolithography is performed on the fourth surface 322 to form a sixth pattern.

As shown in FIG. 9(h), the first sub-board 2 is electroplated to form a fifth conductive pattern and a second conductive channel 24, where the fifth conductive pattern, the second conductive channel 24, and the second conductive pattern 22 form a signal transmission line structure. The second sub-board 3 is electroplated to form a sixth conductive pattern and a third conductive channel 33, where the sixth conductive pattern, the third conductive channel 33, and the third conductive pattern 311 form a signal transmission line structure.

The fifth photoresist 236, the sixth photoresist 326, and the metal layer 6 are removed.

A third sub-board 7 and a fourth sub-board 9 are prepared according to steps of preparing the first sub-board 2 and the second sub-board 3. The third sub-board 7 includes a fourth via extending in a thickness direction of the third sub-board 7, and the third sub-board 7 includes a seventh conductive pattern 71 and an eighth conductive pattern 72 that are disposed opposite to each other in the thickness direction of the third sub-board 7. A difference between an area proportion of the seventh conductive pattern 71 on the fifth surface and an area proportion of the eighth conductive pattern 72 on the sixth surface is less than or equal to 50%. The fourth sub-board 9 includes a fifth via extending in a thickness direction of the fourth sub-board 9, and the fourth sub-board 9 includes a ninth conductive pattern 91 and a tenth conductive pattern 92 that are disposed opposite to each other in the thickness direction of the fourth sub-board 9. A difference between an area proportion of the ninth conductive pattern 91 on the seventh surface and an area proportion of the tenth conductive pattern 92 on the eighth surface is less than or equal to 50%.

As shown in FIG. 9(i), a third insulation layer 8 is taken, and the third insulation layer 8 and the third sub-board 7 are placed on a side that is of the second sub-board 3 and that is away from the core board 1 in a thickness direction of the second sub-board 3, where the third insulation layer 8 is located between the second sub-board 3 and the third sub-board 7.

A fourth insulation layer 1a is taken, and the fourth insulation layer 1a and the fourth sub-board 9 are placed on a side that is of the first sub-board 2 and that is away from the core board 1 in a thickness direction of the first sub-board 2, where the fourth insulation layer 1a is located between the fourth sub-board 9 and the first sub-board 2.

A multi-layer circuit board having five layers of stacked and combined substrates 1b shown in FIG. 9(j) is formed by performing the steps shown in FIG. 9(b) to FIG. 9(h).

In conclusion, in another embodiment, a method for processing a multi-layer circuit board includes the following steps.

As shown in FIG. 10(a), a first substrate 23 is taken, and laser induction is performed on the first substrate 23 to form a second phase change channel 235, where an extension direction of the second phase change channel 235 is parallel to a thickness direction of the substrate 1b.

As shown in FIG. 10(b), the first substrate 23 having two phase change channels is etched to form a second via 241.

As shown in FIG. 10(c), the first substrate 23 includes a first surface 231 and a second surface 232 that are disposed opposite to each other in a thickness direction of the first substrate 23, and a metal layer 6 is sputtered on the first surface 231 and the second surface 232.

As shown in FIG. 10(d), the first surface 231 is covered with first photoresist 233, and the second surface 232 is covered with second photoresist 234.

Photolithography is performed on the first surface 231 to form a first pattern, and photolithography is performed on the second surface to form a second pattern.

As shown in FIG. 10(e), the first pattern, the second pattern, and the second via 241 are electroplated to form a first conductive pattern 21, a second conductive pattern 22, and a second conductive channel 24. The first conductive pattern 21, the second conductive channel 24, and the second conductive pattern 22 form a signal transmission line structure. For example, the first conductive pattern 21 is a signal layer, and the second conductive pattern 22 is a ground layer or a power supply layer.

As shown in FIG. 10(f), the metal layer 6 on the first surface 231 and the second surface 232 is removed to complete processing of a first sub-board 2.

As shown in FIG. 11(a), a second substrate 32 is taken, and laser induction is performed on the second substrate 32 to form a third phase change channel 325, where an extension direction of the third phase change channel 325 is parallel to a thickness direction of the second substrate 32.

As shown in FIG. 11(b), the second substrate 32 having three phase change channels is etched to form a third via 331.

As shown in FIG. 12(a), a first insulation layer 4 is taken, and the first insulation layer 4 is placed on a side of the first substrate 23 in a thickness direction of the first substrate 23, and the second substrate 32 is placed on a side that is of the first insulation layer 4 and that is away from the first substrate 23.

As shown in FIG. 12(b), the first substrate 23, the first insulation layer 4, and the second substrate 32 are fastened through press-fitting.

As shown in FIG. 12(c), a redundant first insulation layer 4 in the third via 331 is removed, and a first through hole 411 is processed in the first insulation layer 4, where the first through hole 411 penetrates the first insulation layer 4 in a thickness direction of the first insulation layer 4.

As shown in FIG. 12(d), a metal layer 6 is sputtered on a surface of the second substrate 32, a side wall of the third via 331, and a side wall of the first through hole 411.

As shown in FIG. 12(e), a surface of the second substrate 32 is covered with fourth photoresist 324.

Photolithography is performed on the second substrate 32 to form a sixth pattern.

As shown in FIG. 12(f), via-filling electroplating is performed on the sixth pattern, the third via 331, and the first through hole 411 to form a conductive pattern layer 31 (namely, the sixth conductive pattern), a third conductive channel 33, and a first conductive part 41, where the sixth conductive pattern, the third conductive channel 33, and the first conductive pattern 21 form a signal transmission line structure.

As shown in FIG. 12(g), the fourth photoresist 324 and the metal layer 6 on the surface of the second substrate 32 are removed.

A third sub-board 7 is processed according to the steps shown in FIG. 11(a) and FIG. 11(b), and the steps shown in FIG. 12(a) to FIG. 12(g) are performed to form a multi-layer circuit board that is formed by stacking and combining a plurality of layers of substrates 1b.

In conclusion, in another embodiment, a method for processing a multi-layer circuit board includes the following steps.

As shown in FIG. 10(a), a first substrate 23 is taken, and laser induction is performed on the first substrate 23 to form a second phase change channel 235, where an extension direction of the second phase change channel 235 is parallel to a thickness direction of the substrate 1b.

As shown in FIG. 10(b), the first substrate 23 having two phase change channels is etched to form a second via 241.

As shown in FIG. 10(c), the first substrate 23 includes a first surface 231 and a second surface 232 that are disposed opposite to each other in a thickness direction of the first substrate 23, and a metal layer 6 is sputtered on the first surface 231 and the second surface 232.

As shown in FIG. 10(d), the first surface 231 is covered with first photoresist 233, and the second surface 232 is covered with second photoresist 234.

Photolithography is performed on the first surface 231 to form a first pattern, and photolithography is performed on the second surface to form a second pattern.

As shown in FIG. 10(e), the first pattern, the second pattern, and the second via 241 are electroplated to form a first conductive pattern 21, a second conductive pattern 22, and a second conductive channel 24. The conductive pattern 21, the second conductive channel 24, and the second conductive pattern 22 form a signal transmission line structure. For example, the first conductive pattern 21 is a signal layer, and the second conductive pattern 22 is a ground layer or a power supply layer.

As shown in FIG. 10(f), the metal layer 6 on the first surface 231 and the second surface 232 is removed to complete processing of a first sub-board 2.

As shown in FIG. 11(a), a second substrate 32 is taken, and laser induction is performed on the second substrate 32 to form a third phase change channel 325, where an extension direction of the third phase change channel 325 is parallel to a thickness direction of the second substrate 32.

As shown in FIG. 11(b), the second substrate 32 having three phase change channels is etched to form a third via 331.

As shown in FIG. 13(a), a first insulation layer 4 is taken, and the first insulation layer 4 is placed on a side of the first substrate 23.

As shown in FIG. 13(b), a first through hole 411 is processed in the first insulation layer 4.

As shown in FIG. 13(c), a fourth conductive medium 412 is placed in the first through hole 411, where the fourth conductive medium 412 is solder or conductive paste, to form a first conductive part 41.

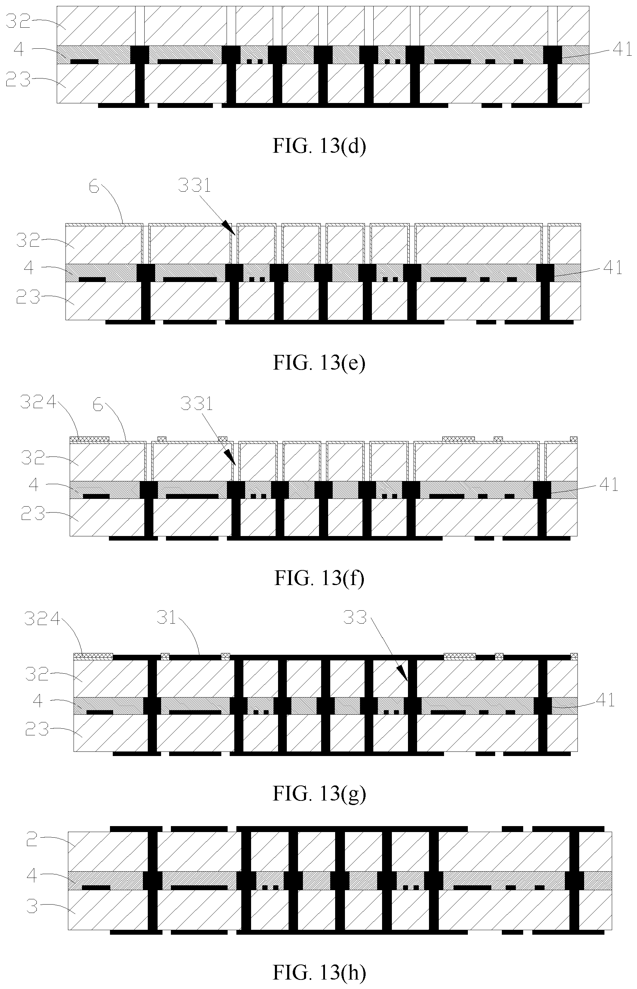

As shown in FIG. 13(d), the second substrate 32 is placed on a side that is of the first insulation layer 4 and that is away from the first substrate 23 in the thickness direction of the first substrate 23.

The first substrate 23, the first insulation layer 4, and the second substrate 32 are fastened through press-fitting.

As shown in FIG. 13(e), a metal layer 6 is sputtered on a surface of the second substrate 32 and a side wall of the third via 331.

As shown in FIG. 13(f), a surface of the second substrate 32 is covered with fourth photoresist 324.

Photolithography is performed on the second substrate 32 to form a sixth pattern.

As shown in FIG. 13(g), via-filling electroplating is performed on the sixth pattern and the third via 331 to form a conductive pattern layer 31 (namely, the sixth conductive pattern) and a third conductive channel 33, where the sixth conductive pattern, the third conductive channel 33, and the first conductive pattern 21 form a signal transmission line structure.

As shown in FIG. 13(h), the fourth photoresist 324 and the metal layer 6 on the surface of the second substrate 32 are removed.

A third sub-board 7 is processed according to the steps shown in FIG. 11(a) and FIG. 11(b), and the steps shown in FIG. 13(a) to FIG. 13(h) are performed to form a multi-layer circuit board that is formed by stacking and combining a plurality of layers of substrates 1b.

Same or similar parts of embodiments of this specification may be referred to each other. Especially, apparatus and terminal embodiments are basically similar to a method embodiment, and therefore are described briefly. For related parts, refer to partial descriptions in the method embodiment.

## Claims

1. A method for processing a multi-layer circuit board, wherein the method for processing a multi-layer circuit board comprises:
taking a first substrate, and processing a first conductive pattern, a second conductive pattern, and a second via in the first substrate, wherein an extension direction of the second via is parallel to a thickness direction of the first substrate, the first substrate comprises a first surface and a second surface that are disposed opposite to each other in the thickness direction of the first substrate, the first conductive pattern is located on the first surface, and the second conductive pattern is located on the second surface;
taking a second substrate, and processing a third via in the second substrate, wherein an extension direction of the third via is parallel to a thickness direction of the second substrate;
taking a first insulation layer, and stacking the second substrate and the first insulation layer on the first substrate in a thickness direction of the first sub-board, wherein the first insulation layer is located between the second substrate and the first substrate; and
fastening the second substrate, the first insulation layer, and the first substrate through press-fitting;
before the step of stacking the second substrate and the first insulation layer on the first substrate, or after the step of fastening the second substrate, the first insulation layer, and the first substrate through press-fitting, the method for processing a multi-layer circuit board comprises:
performing via-filling electroplating on the first substrate to fill a second conductive medium into the second via, to form a second conductive channel; and
after the step of fastening the second substrate, the first insulation layer, and the first substrate through press-fitting, the method for processing a multi-layer circuit board comprises:
electroplating the second substrate, to form a sixth conductive pattern on a side that is of the second substrate and that is away from the first substrate, and fill a third conductive medium into the third via to form a third conductive channel, wherein the first insulation layer comprises a first conductive part, and the first conductive pattern, the second conductive pattern, and the sixth conductive pattern are electrically connected through the third conductive channel, the first conductive part, and the second conductive channel.

2. The method for processing a multi-layer circuit board according to claim 1, wherein when a difference between an area proportion of the first conductive pattern on the first surface and an area proportion of the second conductive pattern on the second surface is less than or equal to 50%, the method for processing a multi-layer circuit board comprises:
preparing a core board, wherein the core board comprises a first conductive channel extending in a thickness direction of the core board;
processing the first conductive pattern and the second conductive pattern on the first substrate; and
processing the second via in the first substrate having the first conductive pattern and the second conductive pattern;
the step of stacking the second substrate and the first insulation layer on the first substrate comprises:
taking a second insulation layer, and stacking the first substrate, the first insulation layer, the core board, the second insulation layer, and the second substrate, wherein the first insulation layer is located between the first substrate and the core board, the second insulation layer is located between the core board and the second substrate, and the first conductive pattern is located on a side that is of the first substrate and that is away from the core board;
the step of fastening the second substrate, the first insulation layer, and the first substrate through press-fitting comprises:
fastening the first substrate, the first insulation layer, the core board, the second insulation layer, and the second substrate through press-fitting; and
after the step of fastening the first substrate, the first insulation layer, the core board, the second insulation layer, and the second substrate through press-fitting, the method for processing a multi-layer circuit board comprises:
removing the first conductive pattern; and
electroplating the first substrate, to form a fifth conductive pattern on the first surface, and fill the second conductive medium into the second via to form the second conductive channel, so as to form the first sub-board, wherein the fifth conductive pattern, the second conductive channel, and the second conductive pattern form a signal transmission line structure, wherein
the second insulation layer comprises a second conductive part, and after the step of electroplating the second substrate to form the sixth conductive pattern and the third conductive channel, the fifth conductive pattern, the second conductive pattern, and the sixth conductive pattern are electrically connected through the second conductive channel, the first conductive part, the first conductive channel, the second conductive part, and the third conductive channel.

3. The method for processing a multi-layer circuit board according to claim 2, wherein the step of preparing the core board comprises:
taking a core substrate, and performing laser induction on the core substrate to form a first phase change channel, wherein an extension direction of the first phase change channel is parallel to a thickness direction of the core substrate;
etching the core substrate having a phase change channel to form a first via;
sputtering a metal layer on an exposed surface of the core substrate;
performing via-filling electroplating on the first via, to form the first conductive channel; and
removing the metal layer on the surface of the core substrate.

4. The method for processing a multi-layer circuit board according to claim 2, wherein before the step of processing the third via in the second substrate, the method for processing a multi-layer circuit board comprises:
taking the second substrate, wherein the second substrate comprises a third surface and a fourth surface that are disposed opposite to each other in the thickness direction of the second substrate, and processing a third conductive pattern on the third surface and processing a fourth conductive pattern on the fourth surface, to form a second sub-board, wherein a difference between an area proportion of the third conductive pattern on the third surface and an area proportion of the fourth conductive pattern on the fourth surface is less than or equal to 50%; and
after the step of fastening the first substrate, the first insulation layer, the core board, the second insulation layer, and the second substrate through press-fitting, the fourth conductive pattern is located on the side that is of the second substrate and that is away from the first substrate, and the method for processing a multi-layer circuit board comprises:
removing the fourth conductive pattern.

5. The method for processing a multi-layer circuit board according to claim 4, wherein the step of processing the first conductive pattern and the second conductive pattern on the first substrate comprises:
taking the first substrate, and sputtering a metal layer on the first surface and the second surface;
covering the first surface with first photoresist, and covering the second surface with second photoresist;
performing photolithography on the first surface to form a first pattern, and performing photolithography on the second surface to form a second pattern;
electroplating the first pattern and the second pattern to form the first conductive pattern and the second conductive pattern; and
removing the first photoresist, the second photoresist, and the metal layer; and
the step of processing the third conductive pattern on the third surface and processing the fourth conductive pattern on the fourth surface comprises:
taking the second substrate, and sputtering a metal layer on the third surface and the fourth surface;
covering the third surface with third photoresist, and covering the fourth surface with fourth photoresist;
performing photolithography on the third surface to form a third pattern, and performing photolithography on the fourth surface to form a fourth pattern;
electroplating the third pattern and the fourth pattern to form the third conductive pattern and the fourth conductive pattern; and
removing the third photoresist, the fourth photoresist, and the metal layer.

6. The method for processing a multi-layer circuit board according to claim 4, wherein the step of electroplating the first substrate comprises:
sputtering a metal layer on the first surface and a side wall of the second via;
covering the first surface with fifth photoresist;
performing photolithography on the first surface to form a fifth pattern;
electroplating the fifth pattern and the second via to form the fifth conductive pattern and the second conductive channel; and
removing the fifth photoresist and the metal layer; and
the step of electroplating the second substrate comprises:
sputtering a metal layer on the fourth surface and a side wall of the third via;
covering the fourth surface with sixth photoresist;
performing photolithography on the fourth surface to form a sixth pattern;
electroplating the sixth pattern and the third via to form the sixth conductive pattern and the third conductive channel; and
removing the sixth photoresist and the metal layer.

7. The method for processing a multi-layer circuit board according to claim 4, wherein the method for processing a multi-layer circuit board further comprises:
preparing a third sub-board, wherein the third sub-board comprises a fourth via extending in a thickness direction of the third sub-board, the third sub-board comprises a fifth surface and a sixth surface that are disposed opposite to each other in the thickness direction of the third sub-board, a seventh conductive pattern is disposed on the fifth surface, an eighth conductive pattern is disposed on the sixth surface, and a difference between an area proportion of the seventh conductive pattern on the fifth surface and an area proportion of the eighth conductive pattern on the sixth surface is less than or equal to 50%;
after the step of fastening the first substrate, the first insulation layer, the core board, the second insulation layer, and the second substrate through press-fitting, the method for processing a multi-layer circuit board comprises:
taking a third insulation layer, and placing the third insulation layer and the third sub-board on a side that is of the second sub-board and that is away from the core board in a thickness direction of the second sub-board, wherein the third insulation layer is located between the second sub-board and the third sub-board, and the eighth conductive pattern is located on a side that is of the third sub-board and that is away from the third insulation layer;
fastening the second sub-board and the third sub-board through press-fitting;
removing the eighth conductive pattern; and
electroplating the third sub-board, to form an eleventh conductive pattern on the sixth surface, and fill a fourth conductive medium into the fourth via to form a fourth conductive channel, wherein the eleventh conductive pattern, the fourth conductive channel, and the seventh conductive pattern form a signal transmission line structure; and the third insulation layer comprises a third conductive part, and the third sub-board is electrically connected to the second sub-board through the fourth conductive channel and the third conductive part; and/or
the method for processing a multi-layer circuit board further comprises:
preparing a fourth sub-board, wherein the fourth sub-board comprises a fifth via extending in a thickness direction of the fourth sub-board, the fourth sub-board comprises a seventh surface and an eighth surface that are disposed opposite to each other in the thickness direction of the fourth sub-board, a ninth conductive pattern is disposed on the seventh surface, a tenth conductive pattern is disposed on the eighth surface, and a difference between an area proportion of the ninth conductive pattern on the seventh surface and an area proportion of the tenth conductive pattern on the eighth surface is less than or equal to 50%; and
after the step of fastening the first sub-board, the first insulation layer, the core board, the second insulation layer, and the second sub-board through press-fitting, the method for processing a multi-layer circuit board comprises:
taking a fourth insulation layer, and placing the fourth insulation layer and the fourth sub-board on a side that is of the first sub-board and that is away from the core board in the thickness direction of the first sub-board, wherein the fourth insulation layer is located between the fourth sub-board and the first sub-board, and the ninth conductive pattern is located on a side that is of the fourth sub-board and that is away from the fourth insulation layer;
fastening the fourth sub-board and the first sub-board through press-fitting;
removing the ninth conductive pattern; and
electroplating the fourth sub-board, to from a twelfth conductive pattern on the seventh surface, and fill a fifth conductive medium into the fifth via to form a fifth conductive channel, wherein the twelfth conductive pattern, the fifth conductive channel, and the tenth conductive pattern form a signal transmission line structure; and the fourth insulation layer comprises a fourth conductive part, and the fourth sub-board is electrically connected to the first sub-board through the fifth conductive channel and the fourth conductive part.

8. The method for processing a multi-layer circuit board according to claim 1, wherein when the first conductive pattern, the second conductive pattern, and the second conductive channel form a signal transmission line structure, the step of performing via-filling electroplating on the first substrate is performed simultaneously with the step of processing the first conductive pattern and the second conductive pattern; and
the step of processing the first conductive pattern, the second conductive pattern, and the second via in the first substrate comprises:
processing the second via in the first substrate;
sputtering a metal layer on the first surface and the second surface of the first substrate having the second via;
covering the first surface with first photoresist, and covering the second surface with second photoresist;
performing photolithography on the first surface to form a first pattern, and performing photolithography on the second surface to form a second pattern; and
electroplating the first pattern, the second pattern, and the second via, to form the first conductive pattern, the second conductive pattern, and the second conductive channel.

9. The method for processing a multi-layer circuit board according to claim 8, wherein the method for processing a multi-layer circuit board further comprises:
preparing a third sub-board, wherein the third sub-board comprises a fourth via extending in a thickness direction of the third sub-board;
after the step of fastening the second substrate, the first insulation layer, and the first substrate through press-fitting, the method for processing a multi-layer circuit board comprises:
taking a third insulation layer, and placing the third insulation layer and the third sub-board on the side that is of the second substrate and that is away from the first substrate in the thickness direction of the second substrate, wherein the third insulation layer is located between the second substrate and the third sub-board;
fastening the third sub-board and the second substrate through press-fitting; and
electroplating the third sub-board, to form an eleventh conductive pattern on a side that is of the third sub-board and that is away from the second substrate, and fill a fourth conductive medium into the fourth via to form a fourth conductive channel, wherein the third insulation layer comprises a third conductive part, and the eleventh conductive pattern is electrically connected to the sixth conductive pattern through the fourth conductive channel and the third conductive part; and/or
the method for processing a multi-layer circuit board further comprises:
preparing a fourth sub-board, wherein the fourth sub-board comprises a fifth via extending in a thickness direction of the fourth sub-board; and
after the step of fastening the second substrate, the first insulation layer, and the first substrate through press-fitting, the method for processing a multi-layer circuit board comprises:
taking a fourth insulation layer, and placing the fourth insulation layer and the fourth sub-board on a side that is of the first substrate and that is away from the second substrate in the thickness direction of the first substrate, wherein the fourth insulation layer is located between the first substrate and the fourth sub-board;
fastening the first substrate and the fourth sub-board through press-fitting; and
electroplating the fourth sub-board, to form a twelfth conductive pattern on a side that is of the fourth sub-board and that is away from the first substrate, and fill a fifth conductive medium into the fifth via to form a fifth conductive channel, wherein the fourth insulation layer comprises a fourth conductive part, and the twelfth conductive pattern is electrically connected to the first conductive pattern through the fifth conductive channel and the fourth conductive part.

10. The method for processing a multi-layer circuit board according to any one of claims 1 to 9, wherein the step of processing the second via in the first substrate comprises:
performing laser induction on the first substrate to form a second phase change channel, wherein an extension direction of the second phase change channel is parallel to the thickness direction of the first substrate; and
etching the first substrate having two phase change channels to form the second via; and
the step of processing the third via in the second substrate comprises:
performing laser induction on the second substrate to form a third phase change channel, wherein an extension direction of the third phase change channel is parallel to the thickness direction of the second substrate; and
etching the second substrate having three phase change channels to form the third via.

11. The method for processing a multi-layer circuit board according to any one of claims 1 to 9, wherein the step of stacking the second substrate and the first insulation layer on the first substrate comprises:
placing the first insulation layer on the first substrate in the thickness direction of the first sub-board; and
placing the second substrate on a side that is of the first insulation layer and that is away from the first substrate in the thickness direction of the first sub-board; and
after the step of fastening the second substrate, the first insulation layer, and the first substrate through press-fitting, the method for processing a multi-layer circuit board comprises:
processing a first through hole in the first insulation layer, wherein the first through hole penetrates the first insulation layer in a thickness direction of the first insulation layer;
sputtering a metal layer on a side wall of the first through hole; and
performing via-filling electroplating on the first through hole, to form the first conductive part.

12. The method for processing a multi-layer circuit board according to any one of claims 1 to 9, wherein the step of stacking the second substrate and the first insulation layer on the first sub-board comprises:
placing the first insulation layer on the first substrate in the thickness direction of the first substrate;
processing a first through hole in the first insulation layer, wherein the first through hole penetrates the first insulation layer in a thickness direction of the first insulation layer;
placing a fourth conductive medium into the first through hole, wherein the fourth conductive medium is solder or conductive paste; and
placing the second substrate on a side that is of the first insulation layer and that is away from the first sub-board in the thickness direction of the first sub-board.

13. A multi-layer circuit board, wherein the multi-layer circuit board is formed through processing according to the method for processing a multi-layer circuit board according to any one of claims 1 to 12.

14. A chip system, wherein the chip system comprises:
a printed circuit board;
a package substrate, wherein the package substrate is mounted on the printed circuit board, and the package substrate is electrically connected to the printed circuit board;
an interposer, wherein the interposer is mounted on the package substrate, and the interposer is electrically connected to the package substrate; and
a plurality of chip dies, wherein the chip dies are mounted on the interposer, and the plurality of chip dies are separately electrically connected to the interposer, wherein
the printed circuit board is the multi-layer circuit board according to claim 13, and/or the package substrate is the multi-layer circuit board according to claim 13.

15. An electronic device, wherein the electronic device comprises:
a device body; and
the chip system according to claim 14, wherein the chip system is mounted on the device body.
